(19) Europäisches Patentamt
European Patent Office
Office européen des brevets

(11) Publication number : **0 635 871 A2**

# (12) EUROPEAN PATENT APPLICATION

(21) Application number : **94112466.1**

(22) Date of filing : **04.11.86**

(51) Int. Cl.[6] : **H01L 21/00,** H01L 23/14, H01L 23/36, C23C 16/50

This application was filed on 10 - 08 - 1994 as a divisional application to the application mentioned under INID code 60.

(30) Priority : **06.11.85 JP 249534/85**
**26.12.85 JP 295434/85**
**22.01.86 JP 11647/86**
**31.03.86 JP 75310/86**
**07.04.86 JP 79875/86**

(43) Date of publication of application :
**25.01.95 Bulletin 95/04**

(60) Publication number of the earlier application in accordance with Art. 76 EPC : **0 221 531**

(84) Designated Contracting States :
**DE FR GB NL**

(71) Applicant : **KANEGAFUCHI KAGAKU KOGYO KABUSHIKI KAISHA**
**2-4 Nakanoshima 3-chome**
**Kita-ku Osaka-shi (JP)**

(72) Inventor : **Yamamoto, Kenji**
**6-530, Maikodai 6-chome,**
**Tarumi-ku**
**Kobe-shi, Hyogo-ken (JP)**
Inventor : **Nakayama, Takehisa**
**9-30-1020, Maikodai 2-chome,**
**Tarumi-ku**
**Kobe-shi, Hyogo-ken (JP)**
Inventor : **Tawada, Yoshihisa**
**14-39, Oikemiyamadai,**
**Kita-ku**
**Kobe-shi, Hyogo-ken (JP)**

(74) Representative : **Türk, Gille, Hrabal, Leifert**
**Brucknerstrasse 20**
**D-40593 Düsseldorf (DE)**

## (54) High heat conductive insulated substrate and method of manufacturing the same.

(57) A high heat conductive insulated substrate comprising a substrate having a heat conductivity of not less than 50 $W/m._k$ and a high heat conductive insulating layer coated on the substrate ; and a method for producing such a high heat conductive insulated substrate by forming an insulating layer on a substrate by applying DC voltage and RF power to the substrate and providing magnetic field parallel to the surface of the substrate, are disclosed.

The insulated substrate of the present invention has a good heat conductivity, a good thermal resistance and a smooth surface, whereby exfoliation of the film layer can be prevented.

FIG. 1

RF POWER SUPPLY
MATCHING CIRCUIT
3
2
1
B
4

EP 0 635 871 A2

The invention relates to a high heat conductive insulated substrate and a method of manufacturing the same.

The packaging density of semiconductor devices has become high with the size, degree of integration and output of electron circuit becoming small, high and large, respectively, by the development in IC (Integrated Circuit), LSI (Large Scale Integration), and the like. As the degree of integration, output and density of semiconductor devices become high or large, the number of devices per one chip becomes larger year by year, whereby the calorific value per one chip increases. There is strongly desired a material for package having high heat conductivity, because the increase of calorific value has a significant influence upon the reliability of semiconductor devices. Further, in the case of hybrid IC, heat-generating parts are disposed in the same package, so there is required a high heat conductive insulated substrate in order to make the packaging density still higher. Still further, in consideration of actually mounting devices on the substrate, the substrate preferably has a coefficient of thermal expansion similar to that of the devices, other material constituting package and circuit substrates, and enables chips to be bonded directly on the substrates.

As a substrate which satisfies the above requirements, there has been proposed a ceramic substrate made of $A\ell$ + $A\ell_2O_3$, crystalline SiC, BeO, $A\ell N$ and the like, or an enamel substrate obtained by covering metal substrate with ceramic. But the above substrates are all expensive except an enamel substrate. The substrate made of BeO has toxicity. The substrate made of crystalline SiC has the problem that the dielectric constant thereof at high frequency is large, i.e. it is about 40 at 1 MHz, because BeO is used as an auxiliary for sintering in crystalline SiC. Further, the substrate made of $A\ell$ + $A\ell_2O_3$ has problems that the heat conductive property and thermal resistance are insufficient, because the coefficient of linear expansion of the substrate is large and insulating property of $A\ell_2O_3$ is in short, thereby epoxy coating is required to compensate these drawbacks. In the case of cheap enamel substrate, it has problems that the coefficient of linear expansion thereof is large and heat conductive property is poor. $A\ell N$ has poor stability to water or alkali.

Recently, there have been produced carbon films having high hardness comprising diamond, diamond-like carbon, i-carbon and the like by means of ion beam vacuum evaporation method, ion beam sputtering method, CVD method, plasma CVD method, and the like. The films have been taken notice of as hard insulating materials.

The term "diamond-like carbon" means a film wherein (1) diamond and amorphous carbon, (2) diamond and graphite, or (3) diamond, graphite and amorphous carbon are mixed.

In case of producing carbon films having high hardness by means of plasma CVD method, and the like, carbon films having high hardness are deposited on a substrate by plasma decomposing a mixed gas of hydrocarbon compound and $H_2$, or inert gas such as Ar or He.

The carbon film obtained by the above manner has large internal stress and selectivity to the substrate. That is, it has good adhesive property to a substrate comprising crystalline silicon, diamond, W, Mo, CuW and the like. However, it has large internal stress and small adhesive strength to a substrate comprising widely-used SUS (stainless steel), $A\ell$, $A\ell$ alloy, Cu, Cu alloy, Ni, Zn, Zn alloy, whereby the exfoliation takes place to shorten the life of the film. That is, in general, the carbon film is easy to exfoliate in the case of a substrate made of $A\ell$, Cu, Cu alloy, stainless steel, and the like having large coefficient of thermal expansion. On the other hand, it is hard to exfoliate in the case of a substrate made of crystalline silicon, W, Mo, CuW and the like of which coefficient of thermal expansion is approximate to that of diamond.

Diamond has been utilized as a material for a heat sink used in semiconductor devices for large power, microwave oscillating devices and VLSI, because diamond has high heat conductivity and good insulating property.

However, in case of producing a diamond-made thin film in practice, there are generally deposited amorphous carbon and graphite besides diamond when forming the film by means of vapor deposition, whereby the growth of diamond is disturbed. Further, thus obtained thin film has a polycrystalline structure, and a graphite layer is formed at an intergranular thereof. Therefore, diamond thin film produced in the above manner is very poor in insulating property, particularly in dielectric breakdown.

There are hereinafter explained problems concerning a conventional thin film made of diamond and/or diamond-like carbon produced by several kinds of vapor phase growth methods.

(1) In the case of heat filament CVD method, a tungsten heater which heats a substrate is heated up to about 2000°C, accordingly large amount of tungsten is vapored, causing a problem that the tungsten heater is exhausted for a short time and becomes easy to cut. Further, there are generated graphite-like portions because of the nonuniformity in temperature caused by a change with the passage of time of the tungsten heater. Thereby, there is a problem that it is difficult to form a film composed solely of diamond in case of producing a thin film having large area.

(2) In the case of ion beam sputtering method or ion plating method, the obtained thin film has problems that the electrical resistivity of the film is lowered and thereby the insulating property thereof becomes insufficient, because the above-mentioned amorphous carbon or graphite except diamond deposites in the thin film.

(3) In the case of microwave CVD method, it is necessary, as described below, to add $H_2$ to reaction gas in order to generate hydrogen radical to remove amorphous carbon or graphite generated in the thin film. That is, it is necessary to dilute $CH_4$, which is a raw material gas, with $H_2$ to lower the concentration of $CH_4$ to not more than 1 %, whereby the velocity of forming a thin film is limited. Further, in case of making an area of the film formed on the substrate large, there is caused a problem that graphite is formed due to nonuniformity of the concentration of hydrogen radical.

When producing thin films made of diamond and/or diamond-like carbon in such manners as described above, it is necessary to etch amorphous carbon or graphite formed in the thin film with hydrogen radical, and the like.

However, in practice, the concentration of hydrogen radical, and the like is apt to become nonuniform throughout the surface of the substrate when, for instance, forming a thin film made of diamond and/or diamond-like carbon on a silicon substrate. Thereby, amorphous carbon or graphite is locally formed to reduce the insulating property. Every film obtained by the above methods has polycrystalline structure. It is impossible to use subsrates coated with these films as high heat conductive insulated substrates, because the formation of graphite at intergranular is unavoidable and thereby sufficient insulating property cannot be obtained. Further, at present, it is impossible to use the above films as insulating films, in case of producing films having large area.

Further, there have been employed flame-coated substrates as metal base substrates, but these substrates have poor surface smoothness. It is impossible to form diamond, diamond-like carbon or SiC each having high heat conductivity on a metal substrate by means of flame coating technique at present.

It has been reported to form diamond or diamond-like carbon on a crystalline silicon substrate, Mo substrate, W substrate or diamond substrate by means of ion beam method, plasma CVD method, thermal CVD method, electron beam CVD method, and the like. But there has not yet been reported to form diamond or diamond-like carbon on Aℓ substrate, Aℓ-Si substrate, Cu substrate, Cu alloy substrate having high heat conductivity, which are used widely and cheap.

The present invention was made to solve the above problems and an object thereof is to provide a high heat conductive insulated substrate and a method of manufacturing the same. That is, an object of the present invention is to provide an insulated substrate which does not have drawbacks of the conventional substrates such as AℓN, crystalline SiC and BeO, i.e. the substrate of the present invention has coefficient of linear expansion closely akin to that of material constituting package such as devices, or circuit substrates; good heat conductivity and thermal resistance; smooth surface; and is able to produce circuits having thick films.

An another object of the present invention is to solve the above problem of exfoliation, to increase the adhesive strength, to reduce the internal stress and to increase the deposition velocity of hard carbon films.

A further object of the present invention is to provide a high heat conductive insulated substrate comprising multilayer films, which has superior insulating property and high heat conductivity.

In accordance with the present invention, there is provided a high heat conductive insulated substrate comprising a substrate of which heat conductivity is not less than 50 W/m.k, and a high heat conductive insulating layer coated on the substrate having the features of claim 1, and a method of producing a high heat conductive insulating substrate characterized in that an insulating layer is formed on a substrate by applying DC voltage and RF power to the substrate and providing magnetic field parallel to a surface of the substrate.

Improvements and preferred embodiments of the invention are subject matter of the dependent claims.

Fig. 1 is a view explaining a plasma CVD apparatus used in producing an insulated substrate of the present invention;

Fig. 2 is a graph showing that Vickers hardness of deposited film is different in the case of applying RF power and applying no RF power, and depending on applied voltage when producing an insulating layer comprising hard carbon of the present invention;

Fig. 3 is a graph showing that adhesive strength of a deposited film is different in the case of applying RF power and applying no RF power, and depending on applied voltage when producing an insulating layer comprising hard carbon of the present invention;

Figs. 4 to 6 are graphs showing the relationships of silicon content and Vickers hardness, adhesive strength and internal stress, respectively;

Fig. 7 is a sectional view showing a structure of an insulating layer in a high heat conductive insulated substrate of the present invention wherein the insulating layer comprises a multilayer film;

Fig. 8 is a schematic view explaining an apparatus for producing a high heat conductive insulated substrate shown in Fig. 7 using plasma CVD method;

Fig. 9 is a sectional view showing a structure of high heat conductive insulated substrate of the present invention wherein an interlayer is interposed between a substrate and insulating layer;

Fig. 10 is a view explaining an apparatus for producing a high heat conductive insulated substrate shown in Fig. 9;

Fig. 11 is a view explaining a plasma CVD apparatus used in producing an insulating layer comprising hard carbon of the present invention; and

Fig. 12 is a view showing measured results of dielectric breakdown of samples A, B and C corresponding to Examples 21, 22 and 23 respectively in Table 4, and of a film produced by conventional method.

An insulated substrate of the present invention, in case of employing crystalline silicon as a substrate, is hereinafter explained. In the present invention, the term "silicon substrate" means a substrate comprising single crystalline silicon or polycrystalline silicon having heat conductivity of not less than 50 W/m·k, and having a shape, for instance, of 10 to 200 mm$\phi$ or 10 to 200 mm and a thickness of 0.1 to 2 mm.

In the present invention, at least a part of the surface of the above substrate is coated with a high heat conductive insulated layer.

The expression "at least a part of the surface of the substrate is coated" means that at least desired part is coated. Therefore, the rate of a coated part to the whole surface of the substrate is not limited, i.e. the whole surface of the substrate might be coated, or only a small part thereof might be coated.

Examples of a material to form a high heat conductive insulating layer of not less than 50 W/m·k, preferably not less than 100 W/m·k include, for instance, diamond, diamond-like carbon, silicon carbide, amorphous silicon carbide, c-BN, h-BN and A$\ell$N. Using at least one of these materials, there is formed an insulating layer having preferably a thickness of 1 to 50 μm, more preferably a thickness of 2 to 20 μm. In case of forming an insulating layer using not less than two kinds of materials, the insulating layer might have a complex structure.

In case of using diamond-like carbon to form an insulating layer, it is preferable that the diamond-like carbon contains not more than 9 atm % of at least one of silicon and Ge atom, since the obtained layer has physical properties close to diamond, i.e. has small internal stress and large adhesive strength. The more preferable content range is 0.1 to 4 atm %. When an amount of silicon or Ge in the film is more than 9 atm %, the heat conductivity is lowered.

Though the details with respect to the above effects caused by a very small amount of Si or Ge are not clear at present, it is considered that $sp^3$ orbit of Si or Ge functions effectively in the nucleation of diamond.

In case of using amorphous silicon carbide to form an insulating layer, amorphous silicon carbide preferably contains not more than 30 atm %, more preferably 0.1 to 10 atm %, of at least one of hydrogen atm and elements of halogen group, to obtain high heat conductivity.

The above insulating layer is preferably used in an insulated substrate, because the insulating layer has usually electrical resistivity of not less than $10^8$ Ω·cm and thermal resistance of not less than 20 V/μm.

Next, there is explained a method of producing a high heat conductive insulated substrate of the present invention using the above-mentioned crystalline silicon substrate.

Method of forming an insulating layer on a single crystalline or polycrystalline silicon substrate is not particularly limited in the present invention, that is, any method can be employed as far as the insulating layer comprising the above materials is formed.

Concrete examples of the above method include, for instance, DC discharge plasma CVD method, RF discharge plasma CVD method, mixed plasma CVD method of DC discharge and RF discharge and mixed plasma CVD method of DC discharge and RF discharge having magnetic field falling at righ angles with electric field. These methods are employable in forming insulating layers comprising diamond, diamond-like carbon, silicon carbide, amorphous silicon carbide, cubic BN, hexagonal BN, and the like. It is preferable to employ a mixed plasma CVD method of DC discharge and RF discharge having magnetic field falling at right angles with electric field in forming an insulating layer comprising diamond, diamond-like carbon, silicon carbide or amorphous silicon carbid, because there can be produced a film having good crystallization and heat conductivity.

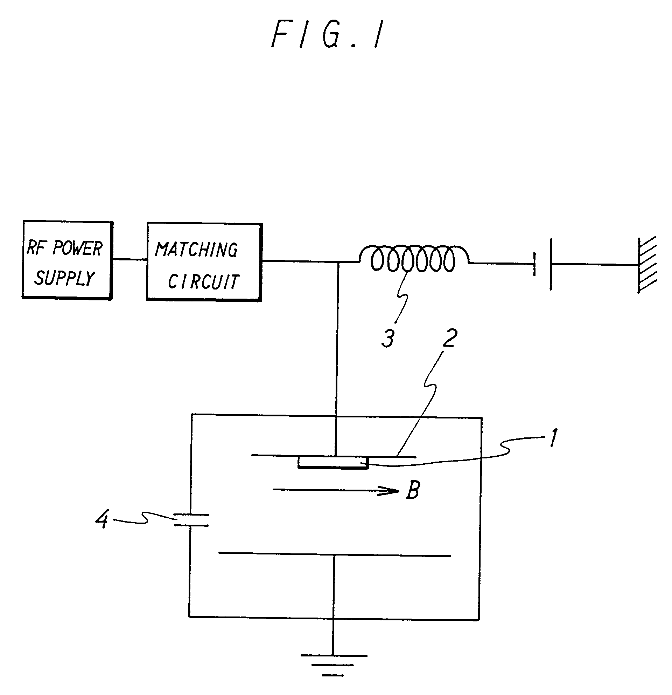

When producing high heat conductive insulated substrates by means of mixed plasma CVD method of DC discharge and RF discharge having magnetic field falling at right angles with electric field, there can be used, for example, an apparatus as shown in Fig. 1. That is, a substrate 1 comprising single crystalline silicon or polycrystalline silicon is set in the apparatus on the side of a RF closing electrode 2. DC voltage of, prefeably, -150 to -600 V is applied to the substrate through a ratio frequency choking coil 3, and RF power of, preferable 100 to 400 W (140 to 560 mW/cm$^2$) is applied to the substrate. Pressure in the reaction chamber and substrate temperature are preferably 0.1 to 20 Torr and 200 to 350°C, respectively. Magnetic field $\underline{B}$ of, preferably, 100 to 1000 gauss is provided parallel to the surface of the substrate. Numeral 4 is a gas inlet.

The substrate of the present invention produced in such a manner as described above has heat conductivity of not less than 50 W/m·k, preferably not less than 100 W/m·k; surface Vickers hardness of not less than 500, preferably not less than 1500 and more preferably not less than 2000; electrical resistivity of not less than 1 x $10^9$Ω·cm, which varies depending on the kind of an insulating layer; dielectric constant at 1 MHz of not more than 20 (in case of silicon carbide, dielectric constant is not more than 15); and dielectric loss at 1 MHz of not more than 0.02.

Further, the insulated substrate is suitable for material of hybrid IC substrate for thick film circuit which requires high temperature treatment, since single crystalline silicon or polycrystalline silicon substrate is used as a substrate to form an insulating layer thereon. The insulated substrate is very stable to acid and alkali.

The insulated substrate of the present invention, wherein a high heat conductive insulating layer is formed on a single crystalline or polycrystalline silicon substrate, is employable as a hybrid IC substrate or a substrate for ratio frequency high power transistor, because the insulated substrate of the present invention has high heat conductivity and low dielectric constant.

Next, there is explained insulated substrate wherein a substrate comprises nitrated or oxidized crystalline silicon. The employable substrates are the same as crystalline silicon substrates described above.

Crystalline silicon used for substrates might be metallic, or doped into p-type or n-type. In case of forming through holes on the substrate,it is prefeable that they are formed before the substrate is nitrated or oxidized from a viewpoint of improving the insulating property of through hole portion.

In the present invention, at least a part of the surface of nitrated or oxidized substrate is coated with a high heat conductive insulating layer.

The nitration or oxidiation of crystalline silicon substrate is carried out in order to obtain uniform and fine insulation, and strong adhesive strength to the insulating layer coated on the substrate after nitration or oxidization. The depth of nitration or oxidization from the surface of a substrte is preferably at least 0.1 μm, more preferably 0.5 μm. On the other hand, from a viewpoint of preventing the strain of internal stress in nitrated or oxidized layer, or cracks caused by the strain, a thickness of nitrated or oxidized layer is preferably not more than 5 μm.

In case of nitrating or oxidizing crystalline silicon substrate, there can be employed a conventional DC discharge method, for example RF discharge method using ratio frequency of about 100 KHz to 50 MHz, or microwave plasma discharge method. In particular, it is preferable to treat crystalline silicon substrate with plasma while biasing minus voltage to the substrate, because high reactivity and strong adhesive strength can be obtained.

The expression "at least a part of the surface of the substrate is coated" means that at least desired part is coated. Therefore, the rate of a coated part to the whole surface of the substrate is not limited, i.e. the whole surface of the substrate might be coated, or only a small part thereof might be coated.

A preferable example of a material to form a high heat conductive insulating layer of not less than 50 W/m·k, preferably not less than 100 W/m·k is such that contains at least one of silicon, germanium and carbon as a main component, i.e. not less than 30 atm %. The material might contain 0.1 to 30 atm % of hydrogen or elements of halogen group.

Concrete examples of the above insulating material include, for instance, hard carbon material such as diamond, diamond-like carbon, silicon carbide and germanium carbide (which are disclosed in the specifications of Japanese Patent Applications No. 83137/1985, No. 179025/1985 and No. 209620/1985, and the like); silicon-containing non single crystalline material such as silicon carbide, silicon nitride, silicon germanium, silicon germanium carbide, silicon carbide nitride, silicon oxide, silicon nitride oxide, silicon carbide oxide (which are disclosed in Japanese Unexamined Patent Publications No. 82669/1985 and No. 119784/1985, and in the specification of Japanese Patent Application No. 187036/1984, and the like); c-BN; h-BN; AℓN; and BP. Using at least one of these materials, there is formed an insulating layer having preferably a thickness of 0.5 to 10 μm, more preferably a thickness of 1 to 10 μm. In case of forming an insulating layer using not less than two kinds of materials, the insulating layer migh have a complex structure.

In case of using diamond-like carbon to form an insulating layer, it is preferable that the diamond-like carbon contains not more than 9 atm % of at least one of silicon and Ge atoms, since the obtained layer has physical properties close to diamond, i.e. has small internal stress and large adhesive strength. The more preferable content range is 0.1 to 4 atm %. When an amount of silicon or Ge in the film is more than 9 atm %, the heat conductivity is lowered.

Though the details with respect to the above effects caused by a very small amoutn of Si or Ge are not clear at present, it is considered that $sp^3$ orbit of Si or Ge functions effectively in the nucleation of diamond.

In case of using amorphous silicon carbide to form an insulating layer, amorphous silicon carbide preferably contains not more than 30 atm %, more preferably 0.1 to 10 atm %, of at least one of hydrogen atom and elements of halogen group, to obtain high heat conductivity.

Among these insulating layers, a layer having electric conductivity of not more than $10^{-6}(\Omega\cdot cm)^{-1}$, preferably not more than $10^{-8}(\Omega\cdot cm)^{-1}$, more preferably not more than $10^{-9}$ $(\Omega\cdot cm)^{-1}$, and withstand voltage of not less than 100 V/μm is suitable for insulated substrate use.

Next, there is explained a method of producing a high heat conductive insulated substrate of the present invention, wherein a nitrated or oxidized crystalline silicon substrate is used.

A method of forming an insulating layer on the surface of nitrated or oxidized crystalline silicon substrate is not particularly limited. Any method is employable as far as an insulating layer comprising the above-mentioned material can be formed. For example, such a method as described in the above Patent Publication or specficiations is preferably employable.

Concrete examples of the above method include, for instance, DC discharge plasma CVD method, RF discharge plasma CVD method, mixed plasma CVD method of DC discharge and RF discharge and mixed plasma CVD method of DC discharge and RF discharge having magnetic field falling at right angles with electric field. These methods are employable in forming insulating layers comprising diamond, diamond-like carbon, silicon carbide, amorphous silicon carbide, cubic BN, hexagonal BN, and the like. It is preferable to employ a mixed plasma CVD method of DC discharge and RF discharge having magnetic field falling at right angles with electric field in forming an insulating layer comprising diamond, diamond-like carbon, silicon carbide or amorphous silicon carbid, because there can be produced a film having good crystallization and heat conductivity.

When producing high heat conductive insulated substrates by means of mixed plasma CVD method of DC discharge and RF discharge having magnetic field falling at right angles with electric field, there can be used, for example, an apparatus as shown in Fig. 1. That is, a substrate 1 comprising single crystalline silicon or polycrystalline silicon is set in the apparatus on the side of a RF closing electrode 2. DC voltage of, prefeably, -150 to -600 V is applied to the substrate through a radio frequency choking coil 3, and RF power of, preferable 100 to 400 W (140 to 560 $mW/cm^2$) is applied to the substrate. Pressure in the reaction chamber and substrate temperature are preferably 0.1 to 20 Torr and 200 to 350°C, respectively. Magnetic field $\underline{B}$ of, preferably 100 to 1000 gausses is provided parallel to the surface of the substrate.

There can be employed ion plating method, cluster beam method, thermal CVD method, ion vacuum evaporation method, and the like besides the above-mentioned method.

The substrate of the present invention produced in such a manner as described above has heat conductivity of about 120 W/m which is almost equal to that of single crystalline silicon; surface Vickers hardness of not less than 500, preferably not less than 1500 and more preferably not less than 2000; electric conductivity of not more than $1 \times 10^{-6}(\Omega\cdot cm)^{-1}$, preferably not more than $1 \times 10^{-8} (\Omega\cdot cm)^{-1}$, which varies depending on the kind of an insulating layer; dielectric constant at 1 MHz of not more than 20 (in case of silicon carbide, dielectric constant is not more than 15); and dielectric loss at 1 MHz of not more than 0.02.

Further, coefficient of thermal expansion of the insulated substrate is almost equal to that of LSI or IC chips since crystalline silicon substrates are used in the present invention. Therefore, the insulated substrate is suitably used for a material of multilayer substrate, or IC substrate such as hybrid IC substrate for thick film circuit requiring high temperature treatment, since chips can be directly bonded on the substrate and the substrate can stand the heating at 800°C. Further, the insulated substrate of the present invention is easy to be electroplated, vacuum evaporated, or sputtered by Cu or the like to obtain a substrate for wiring use. The substrate is still further very stable to acid and alkali, and has good adhesive strength to the insulating layer and high reliability of through holes.

The insulated substrate of the present invention, wherein a high heat conductive insulating layer is deposited on nitrated or oxidized crystalline silicon substrate, has very high electrical resistivity. The heat conductivity thereof is almost equal to that of Si. Furthermore, the undesirable exfoliation of an insulating layer does not take place even when the substrate is repeatedly heated. Si chips such as LSI and IC can be directly bonded on the substrate, since coefficient of linear expansion of the substrate is equal to that of Si chips.

Next, there is explained an insulated subdstrate wherein an insulating layer comprises hard carbon film containing 0.01 to 20 atm % of elements of group IVA. The film is deposited by a method using plasma or ion.

As a method of forming a film using plasma or ion, there can be employed, for instance, ion beam vacuum evaporation method, ion beam sputtering method, sputtering CVD method, plasma CVD method, and the like. However, method employable in the present invention is not limited to those described above. Among these methods, plasma CVD method is preferable, because an apparatus used thereforeis simple and a film having large area can be obtained. In particular, it is preferable to form a hard carbon film by means of DC plasma CVD method, RF plasma CVD method, mixed plasma CVD method of RF and DC, or mixed plasma CVD method of RF and DC in which magnetic field falling at right angles with electric field is provided on the substrate, while mixing a gas of compound containing elements of group IVA into a gas of compound containing carbon. These methods can be employed not only solely but also in joint use.

Preferable examples of metal substrate employable in the present invention include, for instance, stainless steel; Cu; arroy of Cu and $A\ell$, Zn, Cd, Ge, Ti, Ag, Si and the like; $A\ell$; arroy of $A\ell$ and Mn, Mg, Mg-Si, Si, Cu, Mg and the like; Ni; Zn; arroy of Zn and Pb, Fe, Cd, Sn, $A\ell$; W; Mo; and WC. Among these exmaples, substrates made of widely-used stainless steel, Cu, Cu arroy, $A\ell$, $A\ell$ arroy, Ni, Zn, Zn arroy are preferable, because they are economical, easy to get, easy to work and moreover a substrate having large area can be produced with ease.

Hard carbon films in the present invention contain elements of IVA group. Examples of elments of group IVA include, for instance, Si, Ge, Sn. Not less than two elements of these elements can be contained in the hard carbon film. These elements serve to reduce internal stress in the film and to improve adhesive property to metal substrates.

A hard carbon film in the present invention contains 0.01 to 20 atm %, preferably 0.01 to 15 atm %, more preferably 0.01 to 10 atm %, still more preferably 0.1 to 5 atm % and most preferably 1 to 3 atm % of elements of IVA group.

When one kind of element of IVA group is contained in the film, the preferable range of content is 0.01 to 20 atm % in the case of Si, 0.01 to 15 atm % in the case of Ge and 0.01 to 15 atm % in the case of Sn. When not less than two kinds of elements are contained in the film, each content of element should be not more than each maximum content and the total content should be not more than 20 atm %.

When the content of elements of group IVA is less than 0.01 atm %, the properties of the film are almost equal to those of a conventional hard carbon film and therefore there are caused the same problems as caused in case of forming a conventional carbon film on metal substrate. On the other hand, when the content of elements of group IVA is more than 20 atm %, there are caused problems of reduction of adhesive strength, insulating property and hardness, and of increase of internal stress.

The preferable content of elements of group IVA in the film varies depending on the kind and surface condition of the substrate, the kind of elements of group IVA, and the like. For example, preferable content is 0.01 to 10 atm % when Si is contained in stainless steel substrate.

Though the thickness of hard carbon film is not particularly limited in the present invention, the thickness of 10 Å to 100 μm, preferably 20 Å to 30 μm is considered to be producible, because the film is produced by a method using plasma or ion.

Examples of components constituting hard carbon film in the present invention besides above-mentioned elements of group IVA include, for example, carbon, hydrogen used to form conventional hard carbon film, and oxygen residing at the surface of the film. Each content in the film is about 0 to 20 atm %, preferably 0 to 5 atm % in the case of hydrogen, and about 0 to 5 atm %, preferably 0 to 0.1 atm % in the case of oxygen.

In case of using fluorine-containing hydrocarbon such as $CF_4$, $CF_2H_2$ or $CF_3H$ without using hydrocarbon which is generally used as carbon source and hydrogen source, there can be obtained a film containing both hydrogen and fluorine in the film. Further, in case of using chlorine-containing hydrocarbon such as $CC\ell_4$ or $CC\ell_2H_2$, there can be obtained a film containing both chlorine and hydrogen. From a viewpoint of film hardness, a film containing solely hydrogen, or both hydrogen and fluorine is preferable, since the hardness of the film containing chloride is small. A film, which contains chlorine of which content is not less than five times more than that of hydrogen in the number of atoms, tends to cause a problem of exfoliation of the film.

When Si and Ge are contained in a hard carbon film, the content of Si and Ge are preferably not more than 10 atm % and not more than 10 atm %, respectively.

When the content of Si is more than 10 atm %, or that of Ge is more than 10 atm %, the hardness of the film is apt to lower, as is depending on the content of other element of group IVA.

The above-mentioned hard carbon film in the present invention is generally made of diamond or diamond-like carbon. The surface Vickers hardness thereof is 500 to 10000, preferably 1000 to 10000, and more preferably 2500 to 10000. The insulation resistance is $10^2$ to $10^{16}\Omega\cdot cm$, preferably $10^8$ to $10^{16}\Omega\cdot cm$. The adhesvie strength to metal substrate is 5 to 200 kg/cm$^2$, preferably 20 to 200 kg/cm$^2$. The hard carbon film in the present invention is suitably used for the use in insulated substrates for electron circuit, wear-resistant surface coating, and the like.

A hard carbon film in the present invention can be formed as an interlayer on metal substrate such as stainless steel in the thickness of 10 to 5000 Å, preferably 20 to 2000 Å, thereafter a carbon film containing substantially no element of group IVA can be formed thereon. In that case, due to the existence of the interlayer, there can be obtained good adhesion between the metal substrate and the interlayer, and between the interlayer and the carbon film containing substantially no carbon.

Si is not necessarily contained in the film uniformly, but the distribution thereof might be gradient, patterwise. That is, predetermined content have only to be contained in the film as a whole.

Next, there is hereinafter explained a method of producing a hard carbon film in the present invention.

A hard carbon film in the present invention is produced by the reaction of a conventional mixed gas consisting of gases of one or more carbon-containing compounds such as methane, ethane, ethylene, carbon tetrafluoride, acetylene and benzene, and $H_2$ or an inert gas such as Ar, He or the like together with a very small amount of one or more gases selected from the group consisting of gases of silicon-containing compounds such as $SiH_4$, $Si_2H_6$, $SiF_4$, $SiC\ell_4$, $SiH_2F_2$ and $SiH_3F$; gases of germanium-containing compounds such as $GeH_4$, $Ge_2H_6$, $GeF_4$, $GeC\ell_4$, $GeH_2F_2$ and $GeH_3F$; and gases of tin-containing compounds such as $SnH_4$, $SnF_2H_2$,

$SnF_3H$, $SnC\ell_4$ and $SnF_2H_2$. Of course, it is not necessary to control the amounts of carbon-containing compounds and inert gases 50 as to give the same composition as that used in the conventional method of producing a hard carbon film.

There is no particular limitation on the ratio of gas containing elements of group IVA to the carbon-containing compound gas. Thus, the ratio is optional as far as the produced hard carbon film has a predetermined composition. However, in order to give such predetermined composition, the ratio of addition of gas containing elements of group IVA is generally about 0.001 to 10 % , preferably about 0.01 to 1 % by volume.

For example, when a gas containing elements of group IVA is added to carbon-containing gas in the above-mentioned proportion and the hard carbon film of the present invention is formed by plasma CVD method such as DC plasma CVD method, RF plasam CVD method, mixed plasma CVD method of RF and DC wherein magnetic field falling at right angles with electric field is provided on the substrate, the resulting hard carbon film has IVA element content within the required range, good adhesive strength and small internal stress. The content of elements of group IVA in the carbon film can be easily measured by ESCA.

The formation of the hard carbon film might be carried out by usual plasma CVD method. However, when the substrate is disposed on the cathode, a voltage of -300 V to -1 kV is applied to the substrate and DC plasma CVD method is carried out using the above gas, the resulting film has greater hardness and higher electrical resistivity as compared with the film produced by the usual RF plasma CVD method.

The detailed mechanism that the obtained film has good adhesive strength due to the existence of a very small amount of elements of group IVA without exfoliation problems is not yet elucidated. However, it is considered that elements of group IVA contribute to nucleation to reduce the internal stress or improve the adhesive strength to the substrate. That is, carbon, for example, has a mixed form of $SP^3$, $SP^2$ and SP, and $SP^3$ is predominated in the case of silicon, germanium and tin whereby silicon, germanium and tin retain $SP^3$ bond in the growth phase of the film to contribute to nucleation.

A hard carbon film in the present invention can be produced, for example, using DC plasma CVD method under the following conditions:

| | |
|---|---|
| Reaction gas | : $CH_4$ 1 to 50 SCCM |
| | $SiH_4$ 0.01 to 1 SCCM |
| | $H_2$ 10 to 500 SCCM |
| Pressure in the reaction chamber | : 0.1 to 4 Torr |
| Substrate temperature | : room temperature to 400°C |
| Applied voltage | : -200 V to -1 kV |
| DC current | : 0.05 to 6 mA/cm$^2$ |

An another example of production conditions using DC plasma CVD method are as follows:

| | |
|---|---|
| Reaction gas | : $CH_4$ 1 to 50 SCCM |
| | $GeH_4$ 0.01 to 1 SCCM |
| | $H_2$ 10 to 500 SCCM |
| Pressure in the reaction chamber | : 0.1 to 10 Toor |
| Substrate temperature | : room temperature to 500°C |
| Applied voltage | : -300 V to -2 kV |
| DC current | : 0.14 to 6 mA/cm$^2$ |

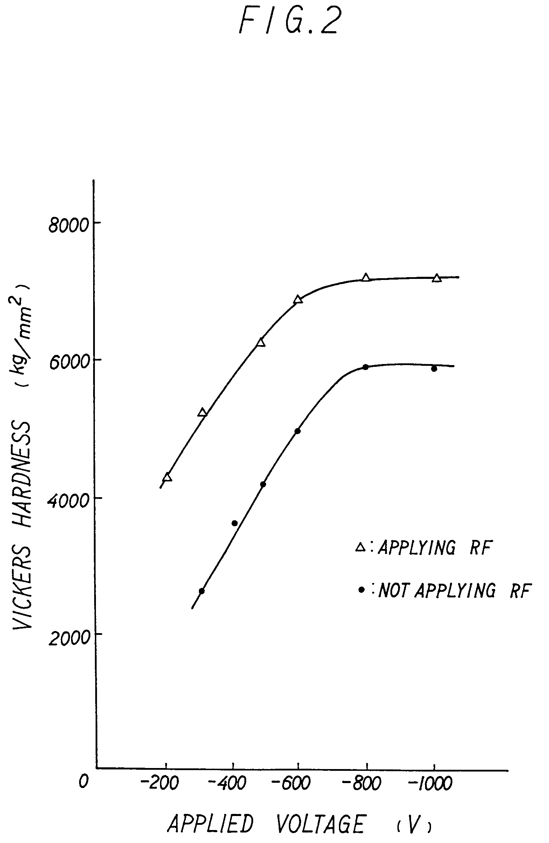

Further, when 14 to 200 mW/cm$^2$ of RF is added to the above DC plasma, discharging is maintained and kept stable even when the insulating material is deposited on the substrate and the deposition velocity is increased, whereby the hardness of the produced film is also increased as shown in Fig. 2.

Fig. 2 shows the results obtained when 40 SCCM of $CH_4$, 100 SCCM of $H_2$ and 0.1 SCCM of $SiH_4$ were added, a substrate made of stainless steel is set on the cathode, and a voltage in the range indicated in Fig. 2 is applied to substrate at a reaction chamber pressure of 1 Torr and a substrate temperature of 350°C to deposit a carbon film on the substrate. The graph in Fig. 2 indicates that the Vickers hardness of the deposited film differs depending on whether 100 mW/cm$^2$ of RF is added or not and that the film hardness varies also depending on the voltage applied. A graph similar to Fig. 2 is obtained when $GeH_4$ is used instead of $SiH_4$.

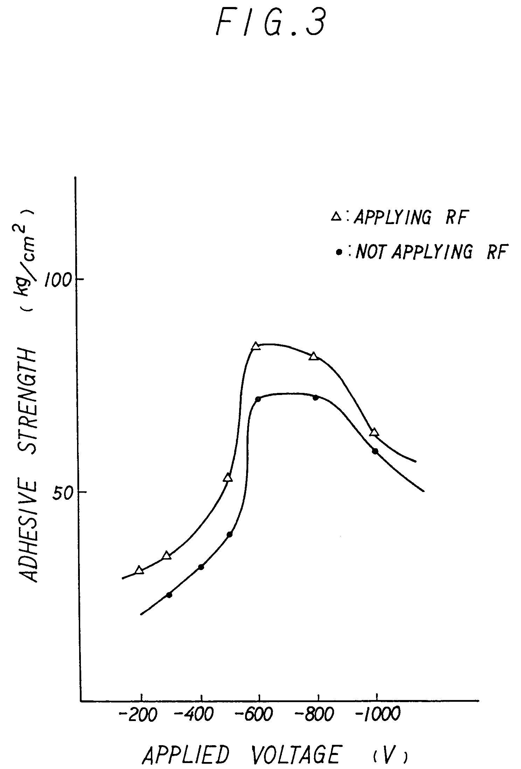

Fig. 3 is a graph indicating that the adhesive strength of the film is also different depending on whether RF is added or not and that the adhesive strength also varies depending on the voltage applied.

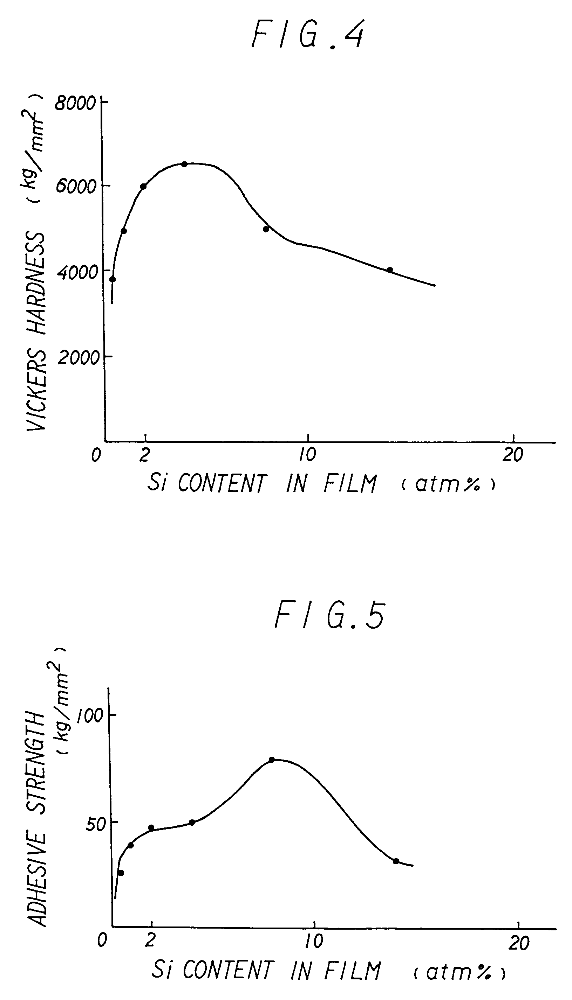

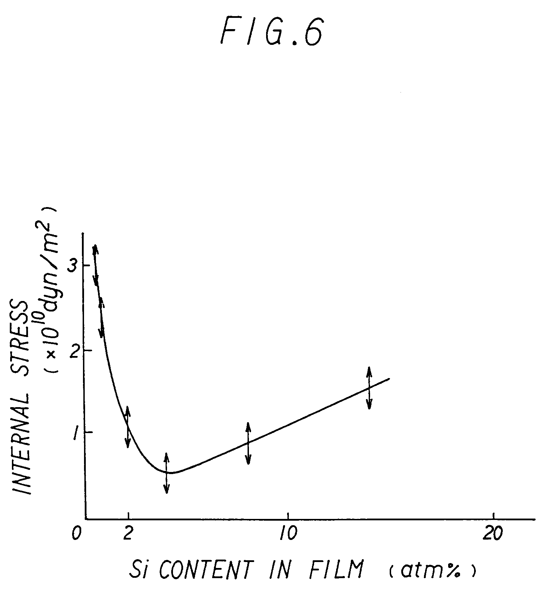

Figs. 4, 5 and 6 are graphs showing the relationship between the Vickers hardness and silicon content in the film formed on the SUS substrate under the conditions set forth in Example 20 which appears hereinafter, the relationship between the adhesive strength and silicon content in the film and the relationship between the internal stress and silicon content in the film, respectively. From these graphs, it is apparent that the introduction of silicon into the film results in a decrease of internal stress and increase of Vickers hardness and adhesive strength. However, an excessively high silicon content leads to a diminution of these effects.

The use of germanium or tin instead of silicon also leads to results similar to those obtained with silicon, although the optimum contents of germanium or tin differs with different elements.

From a viewpoint of film hardness, with the DC voltage being held constant, the hardness is increased when a reactive gas such as methane is diluted with $H_2$ to a low concentration. Thus, when a hydrocarbon gas such as methane is diluted with hydrogen gas to a concentration of not more than 10 % by volume, little film growth is observed unless a gas containing elements of group IVA such as $SiH_4$, $GeH_4$ or $SnH_4$ is added. On the contrary, film growth is observed when plasma CVD is carried out with $SiH_4$, $GeH_4$ or $SnH_4$ added in a very small amount (about 500 ppm based on methane). Moreover, in this case, an exceedingly high film hardness can be obtained.

While the foregoing description relates to the production of the hard carbon film by the plasma CVD method, the hard carbon film of the present invention can also be obtained by other plasma methods or by the method of forming films utilizing ion beams

For example, there can be employed reactive sputtering method using graphite as a target and plasma of a mixed gas consisting of a gas containing a very small amount elements of group IVA and an agron gas, reactive ion beam sputtering method, and ion beam vacuum evaporation method.

The above-mentioned hard carbon film in the present invention has small internal stress, is free of exfoliation problems, hard, good in electrical insulation property and shows a good adhesive property to metal substrates. Therefore, when applied to widely-used substrates made of stainless steel and the like, the film in present invention is suitable for insulated substrate for electronic circuit, wear-resistance coating and other applications.

Next, there is explained a high heat conductive insulated substrate wherein a insulating layer comprises a multilayer film in which a layer of diamond and/or diamond-like carbon and a layer of silicon carbide are accumulated in turn.

In the gas-phase growth method used in the formation of the insulating layer in accordance with the present invention, the kind of a substrate on which a film is formed is an important factor. Of course, a diamond and/or diamond-like carbon film can be formed on a diamond substrate. It is also possible to form a diamond and/or diamond-like carbon film on a silicon carbide or tungusten substrate which tends to form the corresponding carbide. In such cases, if amorphous carbon or graphite is precipitated as mentioned hereinbefore, a diamond and/or diamond-like film can hardly be deposited thereon. Therefore, it is difficult to form a thick and uniform film of diamond and/or diamond-like carbon. To avoid this problem, in the present invention, a very thin insulated film of silicon carbide is formed on the top of a very thin film of diamond and/or diamond-like carbon and such alternating layers are formed to give a multilayer. The silicon carbide film not only seves as an insulating layer but facilitates the formation of diamond and/or diamond-like carbon layers. This is because the preservation of $SP^3$ bonds of silicon carbide prevents precipitation of an $SP^2$ bonds-containing graphite layer on the silicon carbide layer. Generally in the gaseous phase diamond growth method, there is a problem that graphite is once formed, a further amount of graphite is deposited on the layer. However, in the multilayer film in the present invention, even if graphite is formed locally, the formation of a graphite layer is prevented by the overlying silicon carbide layer. Moreover, because of the multilayer construction, no intergranular exist in the layer so that the dielectric breakdown voltage is increasd and there is no decrease of thermal conductivity due to intergranular. Therefore, even when the film surface area is increased, a high heat conductive insulating film having superior dielectric characteristics can be obtained. In regard to thermal conductivity, too, thermal conductivity equivalent to that of diamond can be obtained because silicon carbide is highly heat conductive and thin.

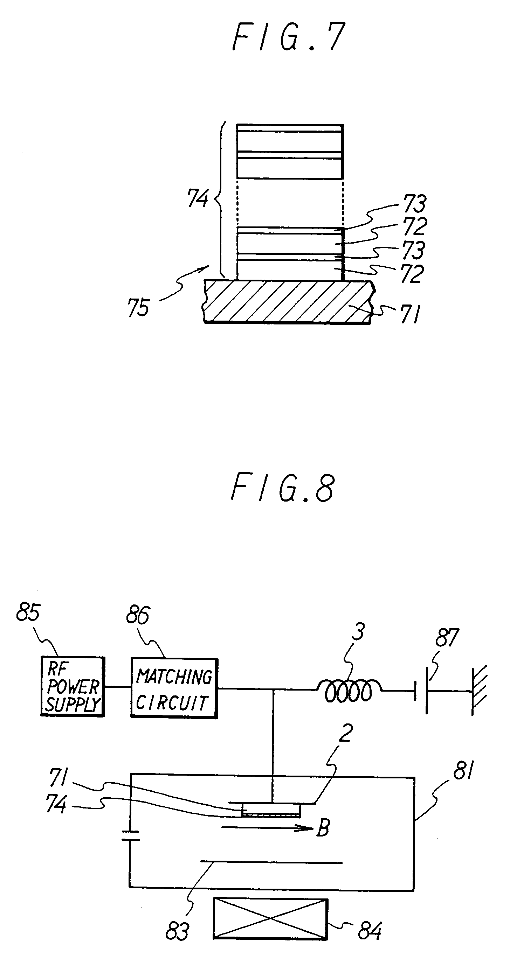

The multilayer insulated substrate having high heat conductivity according to the present invention has a structure as shown in Fig. 7.

In Fig. 7, multilayer, high heat conductive insulated substrate 75 is composed of substrate 71 and multilayer film 74. Any materials can be used as the substrate material so long as they have a heat conductivity of not less than 50 W/m.k. Representative examples of the materials used for the substrate are, for instance, silicon, aluminum, silicon carbide, tungusten, an aluminum alloy, copper, copper alloy, and the like. Silicon, aluminum, silicon carbide and copper are preferred. A layer 72 of diamond and/or diamond-like carbon (hereinafter referred to as "diamond layer") is formed on the substrate 71, and a silicon carbide layer 73 is formed on the diamond layer 72. Further, on the silicon carbide layer 73, the layers 72 and layers 73 are alternately formed in that order, thus providing a multilayer film 74 composed of the diamond layers 72 and silicon carbide layers 73 on the substrate 71. The thicknesses of each diamond layer 72 and each silicon carbide layer 73 vary depending on film-forming conditions. Usually, the thickness of the diamond layer 72 is from 10 to 2,000 Å, and the thickness of the silicon carbide layer 73 is from 10 to 1,000 Å, preferably 10 to 300 Å. For the film-forming conditions which are apt to deposit graphite, it is desirable to form the diamond layer 72 thin. In case of the film-forming conditions which are hard to deposit graphite, the thickness of the diamond layer 72 might be thick. It is preferable that the silicon carbide layer 73 is as thin as possible, but it is required to have a thickness of at least 10 Å, since effects produced by providing the silicon carbide layer are not obtained. In case of microcrystalline silicon carbide or amorphous silicon carbide, silicon carbide of the formula: $Si_{1-x}C_x$ wherein X is from 0 to 0.99, can be used. It is desirable that the average value of X in the layer is from 0.1 to 0.8, especially from 0.4 to 0.6.

The reason why silicon carbide, diamond and diamond-like carbon are used as the components of the multilayer insulation film 74 is that they have very high heat conductivity.

The thickness of the multilayer film 74 varies depending on the insulating property required in the intended uses. In general, it is from 1,000 Å to 20 μm.

It is preferable that the multilayer film 74 has higher heat conductivity than the substrate 71. However, since the multilayer film 74 is thin, the heat conductivity of the multilayer film 74 might be somewhat smaller than that of the substrate 71 so long as the obtained multilayer film-insulated substrate 75 has a heat conductivity of at least 45 W/m.k.

A method for forming the diamond layer 72 and the silicon carbide layer 73 is described below.

Fig. 8 illustrates an apparatus similar to that shown in Fig. 1, used for forming the multilayer film 74 by plasma CVD method. In Fig. 8, the same numerals as in Figs. 1 and 7 indicate the same components or elements. The apparatus shown in Fig. 8 can perform mixed discharge of direct current discharge and radio frequency discharge, and has a magnetic field falling at right angles with electric field. Numeral 81 is a reaction chamber to which raw material gases are introduced. The reaction chamber 81 is provided therein with an electrode 2 and electrode 83 facing and in parallel with each other. The substrate 71 is fixed onto the surface of electrode 2 in contact with electrode 2 and facing electrode 83. A heater 84 for externally heating the substrate is provided on the outer periphery of reaction chamber 81. The apparatus includes radio frequency power source 85 from which radio frequency voltage is supplied through a matching circuit 86, and direct current power source 87 from which direct currect voltage is supplied through a choking coil 3. The magnetic field is applied in the direction crossing the electric field at about right angles, namely in the direction parallel to the drawing paper (in the B direction shown in Fig. 8) and in the direction perpendicular to the drawing paper. The multilayer film 74 is formed on the under surface of substrate 71 in Fig. 8, namely on the surface facing the electrode 83 by conducting a mixed discharge of DC discharge and RF discharge.

In general conditions for forming the diamond layer, the flow rates of the raw material gases are from 100 to 500 SCCM for $H_2$ gas and from 10 to 20 SCCM for $CH_4$ gas. Also, the RF power is from 0.2 to 2 W/cm$^2$, the DC voltage is from -200 V to -1 kV, and the intensity of magnetic field is from 200 to 800 gausses.

The silicon carbide layer is formed generally under the conditions: flow rate of $H_2$ gas of 100 to 500 SCCM, flow rate of $CH_4$ gas of 0.1 to 20 SCCM, flow rate of $SiH_4$ gas of 0.1 to 50 SCCM which is selected so as to be slightly lower than the $CH_4$ flow rate, RF power of 0.1 to 1 W/cm$^2$, DC voltage of -300 V to 1.5 kV, and intensity of magnetic field of 200 to 800 gausses.

Since the multilayer insulating film is formed by alternately depositing the diamond and silicon carbide layers on a heat conductive substrate, the insulating film having high insulating property and high heat conductivity can be obtained even if the film area is made large. The multilayer film-insulated substrate having high heat conductivity according to the present invention is particularly useful as a substrate for integrated circuits.

An interlayer composed of a metal having small coefficient of thermal expansion or an amorphous material might be provided partly or wholly between the substrate and the insulating layer.

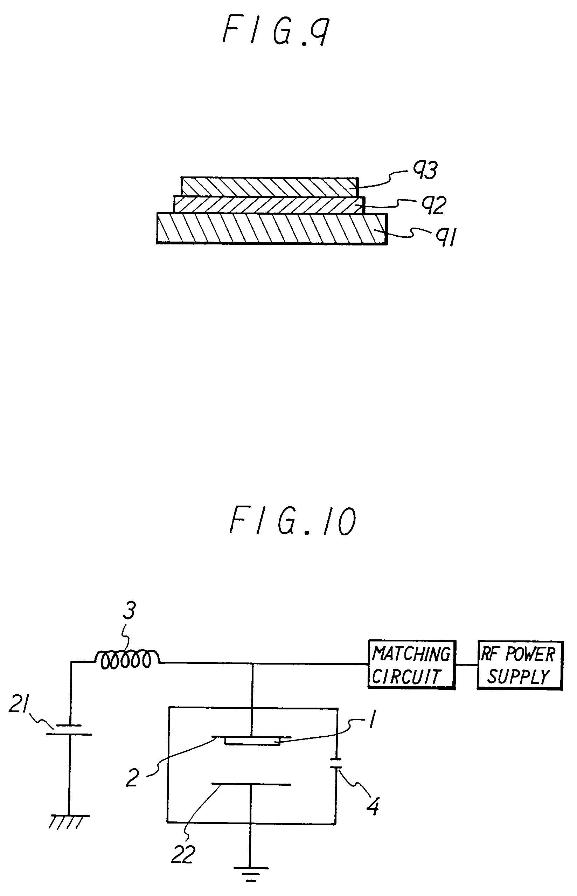

In the high heat conductive insulated substrate of the present invention shown in Fig. 9, an interlayer 92 is formed on at least a part of a high heat conductive metal substrate 91, and heat conductive insulating layer 93 is formed on the intermediate layer.

In this embodiment, any metal substrates made from materials generally used as metal substrates can be used without restriction so long as they have a heat conductivity of at least 50 W/m.k, e.g. Cu, Cu alloy, Aℓ and Aℓ alloy such as Aℓ-Si alloy.

The expression "providing an interlayer on at least a part of a substrate" or similar expression as used herein means that the interlayer is formed in the desired size and shape on the portion required to form the heat conductive insulating layer on the high heat conductive metal substrate. The interlayer 92 might be formed on the entire one or both surfaces of the metal substrate, or may be formed patternwise on a part of the metal substrate.

The interlayer has the following two advantages.

Firstly, since the high heat conductive metal used as a substrate material has a high coefficient of thermal expansion, the heat conductive insulating layer is easy to cause cracks or fissures when the insulating layer, which has a small coefficient of thermal expansion, is formed directly on the metal substrate. The interlayer serves as a buffering layer so as to prevent the insulating layer from causing cracks or fissures.

Secondarily, the interlayer makes it possible or easy to form the insulating layer of a material having high heat conductivity such as silicon carbide, amorphous silicon carbide, diamond or diamond-like carbon on the metal substrate. That is to say, the formation of insulating layer is usually carried out by plasma CVD method, but when the formation on the metal substrate is conducted by this method, the surface temperature of the substrate rises by impingement of ions or the like, thus the insulating film becomes difficult to adhere to the substrate owing to the difference in coefficient between the high heat conductive metal substrate and the insulating film. Even if the film is adhered to the substrate, it exfoliates when allowed to stand at room temperature. Also, sputtering caused by impingement of ions, particularly hydrogen ions, might occur. In case of substrates of Cu, Cu alloy or Aℓ which have high sputter rate, the sputtering proceeds at a higher rate than the film deposition, thus resulting in no film formation. However, when the interlayer is present, the problem resulting from the difference in thermal expansion coefficient and the problem resulting from sputtering are hard to arise, thus the high heat conductive insulating layer can be easily formed.

As the materials used for forming the interlayer, there are mentioned, for instance, a metal having a thermal expansion coefficient of not more than 15 x $10^{-6}$/K, preferably not more than 10 x $10^{-6}$/K, at a temperature between room temperature and 500°C, and an amorphous material capable of relieving the difference in thermal expansion between the metal substrate and the insulating layer, such as amorphous silicon compounds. These materials might be used alone or in admixture thereof.

The thickness of the interlayer is from about 100 Å to about 5 μm, preferably from about 500 Å to about 3 μm. When the thickness is less than 100 Å, there is a tendency that it is difficult to sufficiently relieve the difference in thermal expansion or to form the high heat conductive insulating layer. When the thickness is more than 5 μm, the heat conductivity of the obtained insulated substrate as a whole tends to lower by the influence of the thermal expansion coefficient of the interlayer.

Representative examples of the metal material used for forming the interlayer are, for instance, W, Mo, Pt, Ti, Ni, Ir, Cr, stainless steel, and the like. High melting metals having low sputter rate owing to hydrogen ions, such as Mo, W and Cr, are preferred, since they are easy to form insulating layers and adhere strongly to metal substrates.

The interlayer made of the metal materials as mentioned above is usually formed by sputtering method, electron beam evaporation method, or the like.

Representative examples of the amorphous materials used for forming the interlayer are, for instance, amorphous silicon compounds such as a-Si, a-$Si_xC_{1-x}$, a-$Si_xN_{1-x}$, a-$Si_{x+y}C_{1-x}N_{1-y}$, a-$Si_{x+y}C_{1-x}O_{1-y}$, a-$Si_xGe_{1-x}$, and a-$Si_{x+y}C_{1-x}Ge_{1-y}$ (in these formulas, x and y are valves satisfying the equations: $0.001 \leqq x \leqq 1$ and $0.001 \leqq x+y \leqq 1$), other amorphous compounds, and the amorphous silicon compounds and other amorphous compounds containing at least one of hydrogen and halogens. Among them, the compounds containing at least one of hydrogen and halogens are preferred in points that the interlayer formed therefrom has high structural flexibility, it can effectively relieve the difference in thermal expansion between the metal substrate and the insulating layer and it has a larger adhesion than the others.

As the reaction gas used in forming the interlayer of amorphous materials, there are mentioned, for instance, a gas of a silicon-containing compound such as $SiH_4$, $Si_2H_6$, $SiF_4$, $SiH_3F$ or $SiCℓ_4$; a gas of a hydrocarbon or halogenated hydrocarbon compound such as $CH_4$, $C_2H_4$, $CF_4$, $C_2H_2$, $C_6H_6$ or $C_6H_3F_3$; a gas of a nitrogen-containing compound such as $NH_3$, $N_2$ or $NF_3$; a gas of a Ge-containing compound such as $GeH_4$ or $GeF_4$, and other gases such as $O_2$ and $H_2O$, but the gases usable in the invention are not limited thereto. Diluent gases such as $H_2$, Ar and He might be used.

A layer of an amorphous silicon compound formed by plasma CVD method wherein a mixed discharge of DC discharge and RF discharge is conducted and a negative high voltage is applied to a substrate, is particularly suitable as the interlayer on which the high heat conductive insulating layer is formed. In particular, amorphous silicon carbide is preferred as the amorphous silicon compound from a viewpoint of having a good heat resistance and being hard to be sputtered. In case of producing such an amorphous silicon carbide, it is preferable to use $H_2$, $CH_4$, $SiH_4$ and $CF_4$ from a viewpoint of productivity, namely easiness in forming the film on only the desired place.

Amorphous silicon carbide is used in forming an interlayer and a high heat conductive insulating layer. Amorphous silicon carbide used for an interlayer contains preferably not less than 20 atm % of hydrogen or halogen atoms, and amorphous silicon carbide used for a high heat conductive insulating layer contains preferably crystallized particlulates.

Examples of materials constituting a high heat conductive insulating layer formed after the formation of an interlayer include, for instance, silicon carbide, amorphous silicon carbide, diamond, diamond-like carbon, cubic-BN, hexagonal-BN, all of which having high heat conductivity. Using at least one of these materials, a high heat conductive insulating layer can be formed which has a thickness of about 1000 Å to about 200 μm, preferably 5000 Å to 100 μm, electric conductivity of about not more than $10^{-19}(\Omega\cdot cm)^{-1}$, preferably not more than $10^{-10}$ $(\Omega\cdot cm)^{-1}$, and withstand voltage of not less than 20 V/μm, preferably not less than 40 V/μm.

The high heat conductive insulating layer can be formed by means of ion beam method or thermal CVD method. But plasma CVD method is preferable to obtain a layer having large area. Though diamond or diamond-like thin film using microwave plasma CVD method has been vigorously investigated, DC discharge plasma CVD method, RF discharge plasma CVD method or mixed plasma CVD method of DC discharge and RF discharge is preferable, because the operation is simple and a film having large area can easily be made. The important point in forming a high heat conductive insulating layer is to set a substrate on a cathode, and to dilute raw material gas with hydrogen gas. The more preferable method is mixed plasma CVD method of DC discharge and RF discharge wherein magnetic field falling at right angles with electric field is provided on the substrate. According to this method, there can be formed a higher heat conductive insulating layer. In this method, it is also important to set a substrate on a cathode and to dilute raw material gas with hydrogen gas. The reason why the high heat conductive insulated layer is formed in this method is that crystallization is widely carried out. The crystallization is performed by generating a large amount of hydrogen radical, while controlling the energy distribution of electrons by appropriately adjusting intensity of magnetic field and electric field.

From a viewpoint of obtaining a layer having higher heat conductivity, silicon carbide is more preferable than amorphous silicon carbide, and diamond is more preferable than diamond-like carbon.

Next, there is explained a method of producing a high heat conductive insulated substrate wherein the above interlayer is provided.

Fig. 10 shows an apparatus like in Fig. 1 used in plasma CVD method. In Fig. 10, the same numeral as in Fig. 1 shows the same components elements as in Fig. 1. In Fig. 10, Cu or Aℓ substrate 1 of 0.2 of 5 mm thick is set on the side of a cathode of the apparatus. Amorphous silicon carbide of about 3000 Å to 2 μm thick is deposited on the substrate 1 while introducing a mixed reaction gas from a gas inlet 4 by means of mixed plasma CVD method of DC discharge and RF discharge under the following conditions.

| | |
|---|---|
| Reaction gas | : $H_2$ 50 to 200 SCCM |
| | $SiH_4$ 10 to 50 SCCM |
| | $CH_4$ 10 to 50 SCCM |
| Pressure in the reaction chamber | : 0.1 to 5 Torr |
| DC voltage | : -100 V to -2 kV |
| DC current | : 0.14 to 10 mA/cm$^2$ |
| RF power | : 10 to 500 mW/cm$^2$ |

DC voltage is applied to electrodes 2 and 22 through a radio frequency choking coil 3 from DC power source 21.

The adhesive strength and surface Vickers hardness of the deposited film are 20 to 100 kg/cm$^2$ and 1000 to 3000, respectively. 1 to 30 atm % of hydrogen is contained in the film. The film has structural flexibility.

Next, silicon carbide layer of 5000 Å to 30 μm thick as a high heat conductive insulating layer is formed on the interlayer using almost the same apparatus as in Fig. 10, wherein magnetic field falling at right angles with electric field is provided on the cathode, by generating mixed discharge of DC discharge and RF discharge.

The production conditions are as follows:

| | |
|---|---|
| Reaction gas | : $H_2$ 50 to 200 SCCM |
| | $CH_4$ 5 to 30 SCCM |
| | $SiH_4$ 10 to 60 SCCM |
| Pressure in the reaction chamber | : 0.1 to 10 Torr |
| Intensity of magnetic field | : 100 to 1000 gausses |
| DC voltage | : -150 V to -1 kV |
| DC current | : 0.5 to 15 mA/cm$^2$ |
| RF power | : 50 to 1000 mW/cm$^2$ |
| Substrate temperature | : 200 to 800°C |
| Deposition velocity | : 1 to 15 Å/sec |

The greater part of the obtained film is formed to have generally crystallization type of β-SiC, as a result of X-ray diffraction analysis method. Further, as a result of IR spectrum analysis, a very small amount of hydrogen is found to exist in the film (i.e. small absorption is found in the stretching mode of C-H and Si-H).

In order to form silicon carbide having high heat conductivity, it is important to promote crystallization, to dilute raw material gas with $H_2$ and to adjust energy distribution of electrons by means of three parameters of magnetic field, electric field and pressure in the reaction chamber.

The heat conductivity of the obtained substrate is 0.35 to 0.90 cal/cm·sec·°C around room temperature in case of using a Cu substrate as a metal substrate, of which value is greatly influenced by the thickness and crystallization of the insulating film. It does not lower even when the temperature is raised to around 100°C. The surface Vickers hardness is 2000 to 3500 of which value is almost equal to that of single crystalline β-SiC. Further, the electrical conductivity and withstand voltage are not more than $10^{-12}$ $(\Omega\cdot cm)^{-1}$ and 50 to 200 V/μm, respectively. The exfoliation of interlayer or silicon carbide layer from Cu substrate is not at all observed after one thousand of heat cycles wherein one cycle comprises keeping a substrate at -55°C for 30 minutes and at 150°C for 30 minutes. The adhesive strength is 20 to 100 kg/cm$^2$, of which value does not change even after the test is carried out. The exfoliation is generated between the interlayer and metal substrate, not between the interlayer and insulating layer. The insulated substrate is also suitable for a substrate for thin film circuit, since the surface roughness thereof (average roughness along center line) is not more than 0.1 μm.

The insulated substrate having amorphous silicon carbide layer as an interlayer is explained hereinbefore. Almost the same results can be obtained in case of using such metal as Mo and W as an interlayer.

For example, a metal having low coefficient of thermal expansion such as Mo is vacuum evaporated on a Cu substrate by means of electron beam vacuum evaporation plating method at a velocity of 1 to 5 Å/sec, thereafter the substrate whereon the metal is vacuum evaporated is set in an apparatus as shown in Fig. 10. In that case, like in forming silicon carbide, there is preferably provided magnetic field falling at right angles with electric field on the substrate which was set on a cathode. A film of 1 to 100 μm thick is formed by means of mixed discharge of DC discharge and RF discharge under the following conditions. The substrate is preferably kept at 300 to 800°C.

| | |
|---|---|
| Reaction gas | : $CH_4$ 1 to 5 SCCM |
| | $CF_4$ 1 to 2 SCCM |
| | $H_2$ 100 to 300 SCCM |
| Pressure in the reaction chamber | : 0.1 to 15 Torr |
| Intensity of magnetic field | : 100 to 1000 gausses |
| DC voltage | : -150 to -1 kV |
| DC current | : 1 to 30 mA/cm$^2$ |
| RF power | : 200 to 2000 mW/cm$^2$ |
| Deposition velocity | : 0.1 to 5 Å/sec |

The surface Vickers hardness of the obtained film is very large, i.e. 6000 to 8000 of which value is almost equal to that of natural diamond. As a result of IR spectrum analysis, the existence of hydrogen is not observed. It is found by transmission electron diffraction (TED) that a ring corresponding to (111) and (220) of diamond is produced. The obtained film is such a film as comprises so-called diamond-like carbon.

In order to form a film having properties approximate to those of diamond like in the above formation of silicon carbide layer, it is important to adjust energy distribution of electrons by means of three parameters of magnetic field, electric field and pressure in the reaction chamber.

The different production conditions from those in forming the above silicon carbide layer are that higher RF power, DC voltage, DC current and pressure in the reaction chamber are employed in forming a metal layer.

The heat conductivity of the substrate in case of using a Cu substrate as metal substrate is 0.5 to 0.9 cal/cm·sec·°C around room temperature, and it does not lower even when the temperature is raised up to around 100°C. The surface Vickers hardness is 6000 to 8000. The electrical conductivity and withstand voltage are not more than $10^{-12}$ $(\Omega\cdot cm)^{-1}$ and 40 to 300 V/μm, respectively. The exfoliation is not observed in the heat cycle test. The adhesive strength is 20 to 100 kg/cm$^2$ of which value is the same as that before the test.

The surface Vickers hardness of the substrate of the present invention produced in such a manner as described above is preferably not less than 500, more preferably not less than 1500. Further, the heat conductivity of the high heat conductive insulated substrate is not less than 0.2 cal/cm·sec·°C, more preferably not less than 0.35 cal/cm·sec·°C of which value is approximate to that of metal substrate having high heat conductivity, because the thickness of the interlayer and heat conductive insulating layer is small and the heat conductivity of the heat conductive insulating layer is high. The coefficient of thermal expansion of heat conductive insulating layer is almost equal to that of silicon, in case that the insulating layer is composed of silicon carbon, amorphous silicon carbide, diamond, diamond-like carbon, cubic-BN, hexagonal-BN, and the like, whereby the properties of devices are not deteriorated by the difference of coefficient of thermal expansion. There can be obtained heat conductive insulating layer having superior surface smoothness when the layer is produced by means of plasma CVD method.

In the high heat conductive insulated substrate, there are formed a specific interlayer on metal substrate having high heat conductivity and thereafter heat conductive insulating layer on the interlayer. Therefore, the heat conductive insulating layer is stably and firmly attached to the metal substrate. The substrate of the present invention is preferably used for electronic parts such as hybrid IC substrate, since the substrate of the present invention has high heat conductivity, insulating property and hardness.

Further, in accordance with the above method, there can be obtained substrates of the present invention having above-mentioned interlayers can be produced on industrial scale.

Next, there are explained Examples and Comparative examples of the present invention. Examples 1 to 5 correspond to Claim 2 and Claims depending thereon, Examples 6 to 13 and Comparative Example 1 correspond to Claim 3 and Claims depending thereon, Examples 14 to 20 and Comparative Examples 2 to 5 correspond to Claim 6 and Claims depending thereon, examples 21 to 24 correspond to Claim 7 and Claims depending thereon, and Examples 25 to 29 correspond to Claim 8 and Claims depending thereon.

Examples 1 to 2

SiC film was formed on single crystalline silicon using plasma CVD apparatus as shown in Fig. 1.

Silicon substrate 1 of 100 x 100 x 0.5 mm was set on the side of RF closing electrode 2 as shown in Fig. 1. DC voltage was applied through a radio frequency choking coil 3. Magnetic field B was provided near the substrate in such a direction falling at right angles with a direction of electric field, that is, parallel to the surface of the silicon substrate. The intensity of magnetic field was 100 to 500 gausses. In this apparatus, the substrate was heated up to 200 to 300°C and there was carried out mixed discharge of DC discharge and RF discharge to obtain a silicon carbide film of about 3 to 5 μm thick under the following conditions.

| | |
|---|---|
| Reaction gas (flown from a gas inlet 4) | : $H_2$ 100 to 200 SCCM |
| | $CH_4$ 20 to 80 SCCM |
| | $SiH_4$ 10 to 60 SCCM |
| RF power | : 100 to 300W (140 to 420 $mW/cm^2$) |
| DC voltage | : -150 to -400 V |
| Pressure in the reaction chamber | : 0.3 to 5 Torr |
| Reaction time | : about 1 hour |

The obtained film was found to be microcrystalline β-SiC as a result of X-ray diffraction analysis. Further, as a result of IR measurement, it was found that there existed hydrogen connected to carbon and silicon in the film. The hydrogen content in the film was 1 to 15 atm %.

The characteristics of the obtained films are summarized in Table 1. In Table 1, the thickness of films are about 5 μm, and the carbon content in the films are 40 atm % or 60 atm %.

The characteristics varied depending on the silicon content and carbon content. In general, the hardness increased and heat conductivity decreased when the carbon content was more than 50 atm %.

The reason why the obtained insulated substrate has smaller dielectric constant in comparison with high heat conductive SiC obtained by means of conventional sintering operation is considered that SiC consists of both hydrogen-containing amorphous silicon carbide and crystalline SiC, and not of perfect crystal or polycrystal, accordingly the dielectric constant is reduced by hydrogen-containing amorphous portion and the heat conductivity is increased by crystalline portion.

Example 3

An insulated substrate was made in the same manner as in Example 1 using a conventional RF plasma CVD apparatus having neither magnetic field nor DC power. The obtained film was amorphous. The characteristics of the film containing 40 atm % of carbon are shown in Table 1. The obtained film had superior insulating property and heat conductivity of 50 to 90 W/m·k.

Example 4

A diamond-like carbon film of about 3 to 5 μm thick was obtained using the same apparatus as in Example 1 under the following conditions.

| | |
|---|---|
| Intensity of magnetic field (B) | : 300 to 1000 gausses |
| Substrate temperature | : 250 to 350°C |
| Reaction gas | : $H_2$ 100 to 300 SCCM |
| | $CH_4$ 1 to 10 SCCM |
| RF power | : 100 to 400 W |

| | |
|---|---|
| | (140 to 560 mW/cm$^2$) |
| DC voltage | : -200 to -600 V |
| Pressure in the reation chamber | : 0.1 to 20 Torr |
| Reaction time | : 2 hours |

The experimental conditions of Example 4 differ from those of Example 1 in the points that RF power and DC voltage in Example 4 are higher than those in Example 1, and $CH_4$ is diluted with $H_2$ to not more than 10 % by volume in Example 4. The surface Vickers hardness of the obtained film was 6000 to 8000, of which value was approximate to that of natural diamond. As a result of TED (Transmission Electron Diffraction) analysis, the generation of diamond particles was observed. The characteristics of obtained films varied depending on the production conditions. The characteristics of a film of 5 μm thick obtained by using methane of relatively low concentration (i.e. not more than 5 % by volume) are shown in Table 1. The adhesive strength was small (i.e. 20 to 50 kg/cm$^2$).

Example 5

A diamond-like carbon film was made under the same condition as in Example 4 except that 0.1 to 7 % by weight of silane gas or 0.1 to 5 % by volume of hydrogenated germanium gas was added to methane gas.

The characteristics of the film obtained by adding 0.5 % by volume of silane gas to methane gas are shown in Table 1.

As a result of ESCA measurement, 1 atm % of silicon was observed in the film.

The internal stress of the obtained diamond-like carbon film containing a very small amount of silicon was very small. The adhesive strength was several times larger than a film which does not contain silicon, and further the electric insulation property was improved.

Table 1

| | Ex. 1 | Ex. 2 | Ex. 3 | Ex. 4 | Ex. 5 |
|---|---|---|---|---|---|
| Insulating layer | $SiC_{40}$ | $SiC_{60}$ | a-$SiC_{40}$ | Diamond-like carbon | Diamond-like carbon |
| Heat conductivity (room temperature) (W/m·k) | 100 to 120 | 90 to 110 | 50 to 90 | 100 to 120 | 100 to 120 |
| Coefficient of thermal expansion (x $10^{-6}/^{o}C$) | 3.3 to 3.6 | 3.3 to 3.6 | 3.3 to 3.7 | 3.3 to 3.6 | 3.3 to 3.6 |
| Electrical resistivity (Ω·cm) | $> 10^{14}$ | $> 10^{14}$ | $> 10^{14}$ | $> 10^{11}$ | $> 10^{13}$ |
| Dielectric constant (1 MHz) | 12 to 15 | 12 to 20 | 12 to 15 | 12 to 15 | 12 to 15 |
| Dielectric loss (1 MHz) | 0.01 > | 0.01 > | 0.01 > | 0.01 > | 0.01 > |
| Vickers hardness ($kg/mm^2$) | 2500 to 3000 | 3000 to 3500 | 800 to 900 | 7000 to 8000 | 7000 to 8000 |
| Adhesive strength ($kg/cm^2$) | 100 to 150 | 100 to 150 | 20 to 60 | 20 to 50 | 50 to 150 |
| Withstand voltage | 1 kV < | 600 V < | 1 kV < | 250 V < | 700 V < |

Examples 6 to 13 and Comparative Example 1

Through holes of 0.5 mmϕ were made on single crystalline Si substrate of 0.5 mm thick. After being trimmed and grinded, the substrate was put in a plasma CVD apparatus. The substrate was set on the side of RF electrode and then plasma oxidation was preformed by RF (Radio Frequency) of 13.56 MHz under the following conditions, while introducing $O_2$ of 0.1 Torr into the apparatus.

DC voltage : -100 V
RF power : 0.1 W/cm$^2$
Reaction temperature : Room temperature

The thickness of the oxidized layer was measured by means of SIMS.

Next, the substrate was heated up to 200°C and a-SiC having Eg of 2.5 eV was deposited thereon using RF under the following conditions.

Reaction gas : $SiH_4$ and $CH_4$
DC voltage : -50 V
Pressure in the reaction chamber : 0.5 Torr
RF power : 0.1 W/cm$^2$

The heat conductivity of the obtained substrate was measured by laser flash method. The electric conductivity was measured in a surface direction of a-SiC whereon Aℓ electrodes were provided parallel to each other, and in a direction of the thickness of a-SiC, namely in a direction vertical to the surface of the layer.

The thermal resistance was evaluated by observing the change of a-SiC film after repeatedly raising the temperature thereof three times up to 500°C.

The results are summarized in Table 2. In Table 2, A means "excellent", B means "good" and C means "poor".

Table 2

| | Com. Ex. 1 | Ex. 6 | Ex. 7 | Ex. 8 | Ex. 9 | Ex. 10 | Ex. 11 | Ex. 12 | Ex. 13 |
|---|---|---|---|---|---|---|---|---|---|
| Thickness of $SiO_2$ (μm) | 0 | 0.1 | 0.5 | 1.0 | 0.5 | 0.5 | 0.5 | 0.5 | 0.5 |
| Thickness of a-SiC (μm) | 3 | 3 | 3 | 3 | 0.5 | 1 | 5 | 10 | 20 |
| Heat conductivity (W/m·°C) | 125 | 125 | 120 | 115 | 130 | 130 | 115 | 105 | 80 |
| Electric conductivity (parallel to the surface of the layer) $(\Omega \cdot cm)^{-1}$ | $10^{-15}$ | $10^{-15}$ | $10^{-15}$ | $10^{-16}$ | $10^{-14}$ | $10^{-14}$ | $10^{-15}$ | $10^{-16}$ | $10^{-16}$ |
| Electric conductivity (vertical to the surface of the layer) $(\Omega \cdot cm)^{-1}$ | $10^{-13}$ | $10^{-14}$ | $10^{-15}$ | $10^{-16}$ | $10^{-8}$ | $10^{-10}$ | $10^{-15}$ | $10^{-16}$ | $10^{-16}$ |
| Thermal resistance | C | A or B | A | A | A | A | A | A | B |

Example 14 and Comparative Example 2

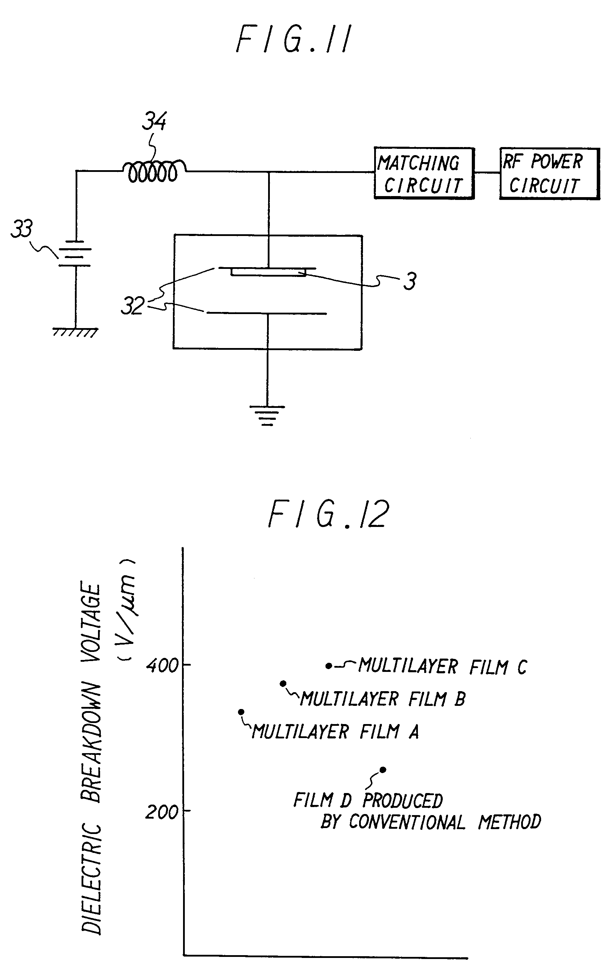

A substrate 3 made of stainless steel was set in a plasma CVD apparatus as shown in Fig. 11 to deposite a film of 10000 Å thick on the substrate 3 under the following conditions.

| | |
|---|---|
| Reaction gas | : $CH_4$ 40 SCCM |
| | $H_2$ 200 SCCM |
| | $SiH_4$ 0.2 SCCM |
| Pressure in the reaction chamber | : 1 Torr |
| DC voltage | : -500 V |
| RF Power | : 100 mW/cm$^2$ |
| Substrate temperature | : 350°C |

In Fig. 11, numeral 32 is an electrode, numeral 33 is DC power and numeral 34 is a RF choking coil. The Vickers hardness and adhesive strength of the deposited film were about 6000 and about 50 kg/cm$^2$, respectively. 2 atm % of silicon was found to be contained in the film according to ESCA measurement. The electrical resistivity of the film was more than $10^{12}\Omega\cdot$cm and the coefficient of friction thereof was 0.2. The film was not exforiated by one hundred of heat cycles from room temperature to 300°C after leaving the film for one month.

On the other hand, a film (Comparative Example 2) obtained by the same method as in Example 14 except that silane gas was not used exforiated just after taking the obtained film out, or after leaving it for one to three days.

Example 15 and Comparative Example 3

A hard carbon film was produced using the same apparatus as shown in Fig. 11. A substrate made of Aℓ-Si was set in the apparatus in the same manner as in the substrate made of stainless steel. A film was deposited under the following conditions.

| | |
|---|---|
| Reaction gas | : $CH_4$ 40 SCCM |
| | $H_2$ 100 SCCM |
| | $SiH_4$ 0.1 SCCM |
| Pressure in the reaction chamber | : 1 Torr |
| DC volatage | : -200 to -1 kV |

A film was obtained by the same condition as described above except that RF of 100 mW/cm$^2$ was further applied to the substrate.

Fig. 2 shows the relationship of surface Vickers hardness of the obtained films and applied voltage, and further the relationship in case of applying RF power. The surface hardness increases with the increase of applied voltage till about -800 V, but is likely to saturate when applied voltage exceeds about -800 V. The content of silicon in the film was found to about 2 atm % regardless of the value of applied voltage by ESCA measurement. The adhesive strength of the films are shown in Fig. 3.

On the other hand, a film (Comparative Example 3) obtained by the same method as in Example 14 except that silane gas was not used exforiated just after taking out the obtained film, or after leaving it for one to seven days.

Example 16

A hard carbon film was produced using a substrate made of stainless steel in the same apparatus as in Fig. 11. The used apparatus can further provide, on the substrate surface, magnetic field which falls at right angles with electric field. The conditions of producing a film were as follows:

| | |
|---|---|
| Intensity of magnetic field | : 200 gauss |
| Reaction gas | : $CH_4$ 40 SCCM |
| | $H_2$ 200 SCCM |
| | $SiH_4$ 0.2 SCCM |
| Substrate temperature | : 350°C |
| DC voltage | : -250 V |
| RF power | : 100 mW/cm$^2$ |
| Pressure in the reaction chamber | : 1 Torr |

The deposition velocity of the film was 10 Å/sec, and the thickness thereof was 10000 Å. Plasma having high density can be generated at low applied voltage due to the existence of magnetic field which falls at right angles with electric field when using the above apparatus.

2 atm % of silicon was contained in the obtained film, and the surface Vickers hardness, adhesive strength, electrical resistivity and coefficient of friction were 7000, 90 kg/cm$^2$, $10^{14}\Omega\cdot$cm and 0.20, respectively. The exfoliation was not observed by one thousand of heat cycles from -60°C to 300°C.

Example 17 and Comparative Example 4

A substrate 31 made of stainless steel was set in a plasma CVD apparatus as shown in Fig. 11 to deposite a film of 3 μm thick on the substrate 31 under the following conditions.

| | |
|---|---|
| Reaction gas | : $CH_4$ 40 SCCM |
| | $H_2$ 200 SCCM |
| | $GeH_4$ 0.2 SCCM |
| Pressure in the reaction chamber | : 1 Torr |
| DC voltage | : -500 V |
| RF power | : 100 mW/cm$^2$ |
| Substrate temperature | : 350°C |

The deposition velocity was 2 Å/sec. The Vickers hardness and adhesive strength of the obtained film were about 6000 and 50 kg/cm$^2$, respectively. 1.5 atm % of Ge was contained in the film. Further, the electrical resistivity and coefficient of friction of the film were more than $10^{12}\Omega\cdot$cm and 0.2, respectively. The film did not exfoliate by one thousand of heat cycles after the film was left for one month, wherein one heat cycle comprises keeping the film at -55°C for 30 minutes and at 200°C for 30 minutes.

On the other hand, a film (Comparative Example 4) obtained by the same method as in Example 17 except that $GeH_4$ was not used exforiated just after taking the obtained film out, or after leaving it for one to three days.

Example 18 and Comparative Example 5

A film of 2 μm thick was produced on a substrate made of stainless steel using the same apparatus as in Fig. 11 which can further provide, on the substrate surface, magnetic field falling at right angles with electric field, under the following conditions.

| | |
|---|---|
| Reaction gas | : $CH_4$ 10 SCCM |
| | $H_2$ 200 SCCM |
| | $GeH_4$ 0.05 SCCM |
| Pressure in the reaction chamber | : 1 Torr |
| DC voltage | : -400 V |
| RF power | : 100 mW/cm$^2$ |
| Intensity of magnic field | : 400 gausses |
| substrate temperature | : 300°C |

The depsition velocity was 3 Å/sec.

The Vickers hardness, adhesive strength, electrical resistivity and coefficient of friction of the film were 8000 (of which value is almost equal to that of natural diamond), 40 kg/cm$^2$, more than $10^{12}\Omega\cdot$cm and 0.2, respectively. 2 atm % of Ge was contained in the film. The film did not exfoliate by one thousand of heat cycles like in Example 17.

The adhesion of film onto the substrate was not observed when carrying out the discharge excluding $GeH_4$ from the above reaction gas. From this fact, it can be conjectured that Ge plays an important role in the growth of core.

Example 19

A hard carbon film was produced using a substrate made of stainless steel in the same apparatus as in Fig. 11. The used apparatus can further provide, on the substrate surface, magnetic field which falls at right angles with electric field. The conditions of producing a film were as follows:

| | |
|---|---|
| Intensty of magnetic field | : 200 gausses |
| Reaction gas | : $CH_4$ 20 SCCM |
| | $H_2$ 200 SCCM |
| | $SnH_4$ 0.1 SCCM |
| Substrate temperature | : 350°C |
| DC voltage | : -280 V |
| RF power | : 50 mW/cm$^2$ |
| Pressure in the reaction chamber | : 1 Torr |

The deposition velocity of the film was 7 Å/sec.

The obtained film contained 2 atm % of Sn and the surface Vickers hardness, adhesive strength and electrical resistivity of the film were 6000, 80 kg/cm$^2$ and more than $10^{13}\Omega\cdot$cm, respectively. The film did not exfoliate by one thousand of heat cycles like in Example 17.

Example 20

A hard carbon film of 1 μm thick was produced using a substrate made of stainless steel in the same apparatus as in Fig. 11 under the following conditions.

Pressure in the reaction chamber : 1 Torr
Substrate temperature : 350°C
RF power : 100 mW/cm$^2$
DC voltage : -500 V
Reaction gas : $CH_4$ 40 SCCM
$H_2$ 200 SCCM
$SiH_4$ (flow rate are shown in Table 3)

Table 3

| No. | a | b | c | d | e | f |
|---|---|---|---|---|---|---|
| Flow rate of $SiH_4$ (SCCM) | 0.05 | 0.1 | 0.2 | 0.3 | 1 | 5 |
| Si content in the film (atm %) | 0.5 | 1 | 2 | 4 | 8 | 14 |

The relationships of silicon content in the obtained film and Vickers hardness, adhesive strength and internal stress are shown in Fig. 4 to 6, respectively.

A film containing no silicon was produced in the same manner as described above, but it was impossible to evaluate the properties of the film because it exfoliated from the substrate made of stainless steel.

Example 21 to 24

Diamond and/or diamond-like carbon layer 72 of 60 Å thick was formed under the following conditions.

Discharging time : 60 seconds
Flow rate of $H_2$ : 20 SCCM
Flow rate of $CH_4$ : 2 SCCM
RF power : 1 W/cm$^2$
DC voltage : -300 V
Intensity of magnetic field : 700 gauss

Discharge was stopped for a moment after the diamond and/or diamond-like carbon layer 72 was formed.

Next, silicon carbide layer 73 of 20 Å thick was formed under the following conditions.

Discharging time : 15 seconds
Flow rate of $H_2$ : 200 SCCM
Flow rate of $CH_4$ : 1 SCCM
Flow rate of $SiH_4$ : 2 SCCM
RF power : 0.3 W/cm$^2$
DC voltage : -400 V
Intensity of magnetic field : 700 gauss

The above two kinds of discharging operation were repeated in order to make polylayer film of Example 23 in Table 4. Other Examples in Table 4 were obtained by the same conditions as in Example 23 except discharging time was changed. Table 4 shows the composition thereof.

Table 5 shows the characteristics of polylayer films of Exmaples 21 to 24 shown in Table 4.

Table 4

| | Substrate | Thickness of diamond and/or diamond-like carbon layer (A) | Thickness of silicon carbide layer (B) | Number of each layer |
|---|---|---|---|---|
| Ex. 21 | Single crystalline silicon | 500 Å | 200 Å | 60 |
| Ex. 22 | " | 100 Å | 30 Å | 300 |
| Ex. 23 | " | 60 Å | 20 Å | 500 |
| Ex. 24 | Aluminum | 500 Å | 200 Å | 60 |

Table 5

| | Ex. 21 | Ex. 22 | Ex. 23 | Ex. 24 |
|---|---|---|---|---|
| Heat conductivity at room temperature (W/m·k) | 100 to 120 | 100 to 120 | 110 to 120 | 150 to 200 |
| Electrical resistivity (Ω·cm) | $>10^{14}$ | $>10^{14}$ | $>10^{14}$ | $>10^{14}$ |
| Dielectric constant (1 MHz) | 12 to 15 | 12 to 15 | 12 to 15 | 12 to 15 |
| Dielectric loss (1 MHz) | $<0.01$ | $<0.01$ | $<0.01$ | $<0.01$ |
| Vickers hardness (kg/mm$^2$) | 5000 to 6000 | 7000 to 8000 | 8000 to 9000 | 1000 to 5000 |
| Adhesive strength (kg/cm$^2$) | $>150$ | $>150$ | $>150$ | $>150$ |
| Withstnad voltage | $>1$ kV | $>1$ kV | $>1$ kV | $>1$ kV |

In Fig. 12 there are shown dielectric breakdown voltage of polylayer films A, B and C obtained by forming fifteen layers, seventy seven layers and one hundred and twenty five layers comprising diamond and/or diamond-like carbon in the same conditions as in Examples 21 to 23 respectively, and forming fifteen layers, seventy seven layers and one hundred and twenty five layers of silicon carbide.

The total thickness of these polylayer films A, B and C was about 1 μm.

As an apparatus of making films, there can be employed not only a plasma CVD apparatus shown in Fig.

8 comprising one reaction chamber, but also an apparatus wherein the substrate is movable, and diamond and/or diamond-like carbon films and silicon carbide films are formed in separate reaction chambers.

The dielectric breakdown voltage was measured by vacuum evaporating Aℓ electrodes of 4 cm in diameter (i.e. 13 $cm^2$ in area) on each film and applying a voltage thereto.

As is clear from Fig. 12, each polylayer film (A, B and C) has sufficient insulation property, though the area thereof are large (i.e. 13 $cm^2$).

In Fig. 12, there is further shown a dielectric breakdown voltage of diamond and/or diamond-like carbon film D of 1 μm thick produced by a conventional method.

The dielectric breakdown voltage can be increased by polylayer films, because the dielectric breakdown voltage is determined by such a portion that has the poorest dielectric strength and therefore, in a conventional film, the dielectric strength is lowered due to the existence of graphited portion though the amount thereof is very little.

Example 25

Cu substrate of 1 mm thick was set on the side of a cathode of the apparatus as shown in Fig. 10. Amorphous silicon carbide of about 1 μm thick was deposited by means of mixed plasma CVD method of DC discharge and RF discharge, while introducing a mixed gas of $H_2$, $SiH_4$ and $CH_4$ from a gas inlet 4 under the following conditions.

| | |
|---|---|
| Reaction gas | : $H_2$ 100 SCCM |
| | $SiH_4$ 30 SCCM |
| | $CH_4$ 30 SCCM |
| Pressure in the reaction chamber | : 1.0 Torr |
| DC voltage | : -600 V |
| DC current | : 5 mA/$cm^2$ |
| RF power | : 50 mW/$cm^2$ |

DC voltage was applied to electrodes 2, 22 by DC power 21 through a radio frequency choking coil 3.

The adhesive strength and surface Vickers hardness were 50 kg/$cm^2$ and 1500, respectively. Further, 18 atm % of hydrogen was contained in the film. The film has structural flexibility. Next, on the interlayer, there is formed a silicon carbide layer as a heat conductive insulating layer using an apparatus almost the same apparatus as shown in Fig. 10, wherein magnetic field was provided in a direction perpendicular to electric field on the cathode whereon the substrate was set. Mixed discharge of DC discharge and RF discharge was employed. The production conditions were as follows:

| | |
|---|---|
| Reaction gas | : $H_2$ 150 SCCM |
| | $CH_4$ 20 SCCM |
| | $SiH_4$ 30 SCCM |
| Pressure in the reaction chamber | : 1.0 Torr |
| Intensity of magnetic field | : 600 gausses |
| DC voltage | : -400 V |
| DC current | : 7 mA/$cm^2$ |
| RF power | : 500 mW/$cm^2$ |
| Substrate temperature | : 300°C |

The deposition velocity was 5 Å/sec and the thickness of the layer was 5 μm.

As a result of X-ray diffraction analysis method, the film produced under the above-mentioned conditions was found to have a crystallization type of β-SiC.

The heat conductivity of the film was 0.70 cal/cm·sec·°C around room temperature, and it did not lower (it was almost the same value as in room temperature) even when the temperature was raised up to around 100°C. The surface Vickers hardness was 3200 of which value was almost equal to that of single crystalline β-SiC. Further, the electrical conductivity and withstand voltage were not more than $10^{-14}$ $(\Omega \cdot cm)^{-1}$ and not less than 1 kV, respectively. The exfoliation of interlayer or silicon carbide layer from Cu substrate was not at all observed after one thousand of heat cycles wherein one cycle comprised keeping the substrate at -55°C for 30 minutes and at 150°C for 30 minutes. The adhesvie strength was 50 kg/$cm^2$, of which value was the same as that before the test. The exfoliation was generated between the interlayer and metal substrate, not between the interlayer and insulating layer. The insulated substrate was also suitable for a substrate for thin film circuit, since the surface roughness thereof (average roughness along center line) was not more than 0.1 μm.

Exmaple 26

Mo layer of 1000 Å thick was deposited on Aℓ substrate of 1 mm thick by means of EB vacuum evaporation plating method at room temperature. The deposition velocity was about 1 Å/sec.

Next, on the interlayer, there is formed a silicon carbide layer as a heat conductive insulating layer using an apparatus almost the same as shown in Fig. 10, wherein magnetic field was provided in a direction perpendicular to electric field on an cathode whereon the substrate was set. Mixed discharge of DC discharge and RF discharge was employed. The production conditions were as follows:

| | |
|---|---|
| Reaction gas | : $H_2$ 150 SCCM |
| | $CH_4$ 20 SCCM |
| | $SiH_4$ 30 SCCM |
| Pressure in the reaction chamber | : 1.5 Torr |
| Intensity of magnetic field | : 500 gausses |
| DC voltage | : -300 V |
| DC current | : 7 mA/cm$^2$ |
| RF power | : 500 mW/cm$^2$ |
| Substrate temperature | : 200°C |

The deposition velocity was 4 Å/sec and the thickness of the layer was 5 μm.

As a result of X-ray diffraction anlysis method, the produced film was found to have a crystallization type of β-SiC. A very small amount of hydrogen was found to exist in the film, as a result of IR spectrum analysis (i.e. small absorption was found in the stretching modes of C-H and Si-H).

The heat conductivity of the film was 0.40 cal/cm·sec·°C around room temperature, and it did not lower (it was almost the same value as in room temperature) even when the temperature was raised up to around 100°C. The surface Vickers hardness was 3200 of which value was almost equal to that of single crystalline β-SiC. Further, the electrical conductivity and withstand voltage were not more than $10^{-14}$ $(\Omega\cdot cm)^{-1}$ and not less than 1 kV, respectively. The exfoliation of interlayer or silicon carbide layer from Cu substrate was not at all observed after one thousand of heat cycles wherein one cycle comprised keeping a substrate at -55°C for 30 minutes and at 150°C for 30 minutes. The adhesvie strength was 100 kg/cm$^2$, of which value was the same as that before the test. The exfoliation was generated between the interlayer and metal substrate, not between the interlayer and insulating layer. The insulated substrate was also suitable for a substrate for thin film circuit, since the surface roughness thereof (average roughness along center line) was not more than 0.1 μm.

In the above Exampoes 25 and 26, amorphous silicon carbide and Mo were employed as an interlayer. However, almost the same results can be obtained in case of using such a metal as Pt, Ti, Cr, Ni or W as an interlayer.

Example 27

Mo layer of 1000 Å thick was vacuum evaporated on Cu substrate by means of EB vacuum evaporation plating method. The substrate was set in the same apparatus as shown in Fig. 10. In that case, there was provided magnetic field falling at right angles with electric field on the substrate which was set on a cathode. A film was deposited on the substrate by means of a mixed discharge of DC discharge and RF discharge, while heating the substrate from the outside of a reaction chamber.

The production conditions were as follows:

| | |
|---|---|
| Reaction gas | : $CH_4$ 2 SCCM |
| | $H_2$ 200 SCCM |
| Pressure in the reactive chamber | : 5 Torr |
| Intensity of magnetic field | : 600 gausses |
| DC voltage | : -280 V |
| DC current | : 10 mA/cm$^2$ |
| RF power | : 200 mW/cm$^2$ |
| Substrate temperature | : 400°C |

The deposition velocity and thickness of the obtained film were 1 A/sec and 5 μm, respectively.

The surface Vickers hardness of the obtained film was very large, i.e. 7500 of which value was almost equal to that of natural diamond. As a result of IR spectrum analysis, the existence of hydrogen was not observed. It was found by transmission electron diffraction (TED) that a ring corresponding to (111) and (220) of diamond was produced. The obtained film was a film comprising so-called diamond-like carbon.

The heat conductivity of the film was 0.75 cal/cm·sec·°C around room temperature, and it did not lower even when the temperature was raised up to around 100°C. The electrical comductivity and withstand voltage

were about $10^{13}$ $(\Omega\cdot cm)^{-1}$ and 700 V, respectively. The exfoliation was not observed in the heat cycle test. The adhesive strength was 100 $kg/cm^2$ of which value was the same as that before the test.

Example 28

Cu substrate, whereon amorphous silicon carbide layer of 5000 Å thick was formed as an interlayer like in Example 25, was set in the same apparatus as shown in Fig. 10. In that case, there was provided mangetic field falling at right angles with electric field on the substrate which was set on a cathode. A film of 5 µm thick was formed by means of a mixed discharge of DC discharge and RF discharge under the following conditions, while heating the substrate from the outside of a reaction chamber.

| | |
|---|---|
| Reaction gas | : $CH_4$ 3 SCCM |
| | $CF_4$ 1 SCCM |
| | $H_2$ 200 SCCM |
| Pressure in the reaction chamber | : 7 Torr |
| Intensity of magnetic field | : 700 gausses |
| DC voltage | : -300 V |
| DC current | : 15 $mA/cm^2$ |
| RF power | : 250 $mW/cm^2$ |
| Deposition velocity | : 3 A/sec |
| Substrate temperature | : 400°C |

The surface Vickers hardness of the obtained film was very large, i.e. 8000 of which value was almost equal to that of natural diamond. As a result of IR spectrum analysis, the existence of hydrogen was not observed. It was found by transmission electron diffraction (TED) that a ring corresponding to (111) and (220) of diamond was produced. The obtained film was a film comprising so-called diamond-like carbon.

The heat conductivity of the film was 0.75 cal/cm·sec·°C around room temperature, and it did not lower even when the temperature was raised up to around 100°C. The electrical comductivity and withstand voltage were about $10^{14}$ $(\Omega\cdot cm)^{-1}$ and about not less than 1 kV, respectively. The exfoliation was not observed in the heat cycle test. The adhesive strength was 100 $kg/cm^2$ of which value was the same as that before the test.

Example 29

Aℓ substrate, whereon Mo layer of 1000 Å thick was formed as an interlayer like in Example 26, was set in the same apparatus as shown in Fig. 10. In that case, there was provided mangetic field falling at right angles with electric field on the substrate which was set on a cathode. A film of 5 µm thick was formed by means of a mixed discharge of DC discharge and RF discharge, while heating the substrate from the outside of a reaction chamber under the following conditions.

| | |
|---|---|
| Reaction gas | : $CH_4$ 2 SCCM |
| | $H_2$ 200 SCCM |
| Pressure in the reaction chamber | : 5 Torr |
| Intensity of magnetic field | : 700 gausses |
| DC voltage | : -250 V |
| DC current | : 10 $mA/cm^2$ |
| RF power | : 200 $mW/cm^2$ |
| Deposition velocity | : 1 Å/sec |
| Substrate temperature | : 300°C |

The surface Vickers hardness of the obtained film was very large, i.e. 7000. As a result of IR spectrum analysis, the existence of hydrogen was not observed. It was found by transmission electron diffraction (TED) that a ring corresponding to (111) and (220) of diamond was produced. The obtained film was a film comprising so-called diamond-like carbon.

The heat conductivity of the film was 0.45 cal/cm·sec·°C around room temperature, and it did not lower even when the temperature was raised up to around 100°C. The electrical comductivity and withstand voltage were about $10^{13}$ $(\Omega\cdot cm)^{-1}$ and about 1 kV, respectively. The exfoliation was not observed in the heat cycle test. The adhesive strength was 100 $kg/cm^2$ of which value was the same as that before the test.

## Claims

1. High heat conductive insulated substrate (1; 75), comprising a substrate (71; 91) having a heat conductivity of not less than 50 W/m k and a high heat conductive insulating layer (74; 93) coated on the substrate (71; 91),

**characterized in that**

the insulating layer comprises a multilayer film (74; 93) wherein a layer (72), comprising one or more materials selected from the group consisting of diamond, diamond-like carbon, silicon carbide, amorphous silicon carbide, cubic boron nitride, hexagonal boron nitride and aluminium nitride, and a layer (73) of silicon carbide or a material which mainly comprises at least one of silicon, Ge and carbon and might contain hydrogen or element of halogen group, are accumulated in turn.

2. Substrate according to claim 1, characterized in that an interlayer (92) comprising metal or amorphous material having a small coefficient of thermal expansion is provided at least on a part of the substrate (91), the insulating layer (93) being formed thereon.

3. Substrate according to claim 1 or 2, characterized in that the diamond-like carbon contains not more than 9 atm % of at least one of silicon and germanium atom.

4. Substrate according to anyone of claims 1 to 3, characterized in that the amorphous silicon carbide and the diamond-like carbon contain at least one element of hydrogen atom and elements of halogen group.

5. Substrate according to anyone of claims 1 to 4, characterized in that the thickness of the layers (72) of diamond and/or diamond-like carbon is 1 nm to 200 nm (10 A to 2000 Å).

6. Substrate according to anyone of claims 1 to 5, characterized in that the thickness of the layers (73) of silicon carbide is 1 nm to 100 nm (10 Å to 1000 Å), not less than two layers of silicon carbide being provided.

7. Substrate according to anyone of claims 1 to 6, characterized in that the insulating layer (74; 93) has an electric resistivity of not less than $10^8$ Ω·cm and a thermal resistance of 20 V/μm.

8. Substrate according to anyone of claims 1 to 7, characterized in that the heat conductivity of the insulated substrate (1; 75) is not less than 50 W/m k.

9. Substrate according to anyone of claims 1 to 8, characterized in that the heat conductivity of the insulated substrate (1; 75) is not less than 100 W/m k.

10. Substrate according to anyone of claims 1 to 9, characterized in that the surface Vickers hardness of the insulated substrate (1; 75) is not less than 500.

11. Substrate according to anyone of claims 1 to 10, characterized in that the surface Vickers hardness of the insulated substrate (1; 75) is not less than 1500.

12. Substrate according to anyone of claims 1 to 11, characterized in that the dielectric constant and the dielectric loss at 1 MHz of the insulated substrate (1; 75) are not more than 20 and not more than 0.02, respectively.

13. Substrate according to anyone of claims 1 to 12, characterized in that the thickness of the insulating layer (74; 93) is 0.5 to 10 μm.

14. Substrate according to anyone of claims 1 to 13, characterized in that the thickness of the insulating layer (74; 93) is 1 to 10 μm.

15. Substrate according to anyone of claims 1 to 14, characterized in that the electric conductivity of the insulating layer (74; 93) is not more than $10^{-6}\Omega^{-1}\text{cm}^{-1}$.

16. Substrate according to anyone of claims 1 to 15, characterized in that the heat conductivity of the substrate (71; 91) is not less than 50 W/m k and the heat conductivity of the insulated substrate (1; 75) is not less than 45 W/m k.

17. Substrate according to anyone of claims 1 to 16, characterized in that the electric resistivity and the dielectric breakdown voltage of the insulating layer (74; 93) are not less than $10^{12}$ Ω · cm and not less than 100 V/μm, respectively.

**18.** Substrate according to anyone of claims 1 to 17, characterized in that the silicon carbide is single crystalline, polycrystalline, microcrystalline or amorphous.

**19.** Substrate according to anyone of claims 1 to 18, characterized in that the interlayer (92) comprises amorphous silicon compound containing at least one of a-Si, a-$Si_x C_{1-x}$, a-$Si_x N_{1-x}$, a-$Si_{x-y} C_{1-x} N_{1-y}$, a-$Si_{x+y} C_{1-x} O_{1-y}$, a-$Si_x Ge_{1-x}$ and a-$Si_{x+y} C_{1-x} Ge_{1-y}$, wherein x and y satisfy the relations of $0.0001 \leqq x \leqq 1$ and $0.001 \leqq x+y \leqq 1$.

**20.** Substrate according to anyone of claim 1 to 19, characterized in that the amorphous silicon compound contains (A) at least one of a-Si, a-$Si_x C_{1-x}$, a-$Si_x N_{1-x}$, a-$Si_{x+y} C_{1-x} N_{1-y}$, a-$Si_{x+y} C_{1-y} O_{1-y}$, a-$Si_x Ge_{1-x}$ and a$Si_{x+y} C_{1-x} Ge_{1-y}$, wherein x and y satisfy the relations of $0.001 \leqq x \leqq 1$ and $0.001 \leqq x+y \leqq 1$, and (B) at least one of hydrogen and elements of halogen group.

**21.** Substrate according to anyone of claims 1 to 20, characterized in that the thickness of the interlayer (92) is 10 nm (100 Å) to 5 µm.

**22.** Substrate according to anyone of claims 1 to 21, characterized in that the thickness of the insulating layer (74; 93) is 100 nm (1000 Å) to 200 µm.

**23.** Method for producing a high heat conductive insulated substrate (1; 75) of the type as claimed in anyone of claims 1 to 22, characterized in that the insulating layer (74; 93) is deposited on the metall substrate (71; 91) by applying DC voltage and RF power to the substrate and by providing a magnetic field (B) parallel to the surface of the substrate.

**24.** Method according to claim 23, in which at least a part of the crystalline silicon, nitrated or oxidized silicon substrate (71; 91) is coated with a high heat conductive insulating layer (74; 93), characterized in that the crystalline silicon, nitrated or oxidized substrate is set on one side of an RF closing electrode (2; 32), RF power is applied to the electrode, and a magnetic field (B) is provided parallel to the surface of the substrate (1; 75).

FIG. 1

RF POWER SUPPLY
MATCHING CIRCUIT
3
2
1
B
4

FIG.2

8000
6000
4000
2000
0
-200
-400
-600
-800
-1000
VICKERS HARDNESS (kg/mm2)
APPLIED VOLTAGE (V)
△: APPLYING RF
•: NOT APPLYING RF

FIG.3

△: APPLYING RF
●: NOT APPLYING RF
ADHESIVE STRENGTH (kg/cm²)
100
50
-200
-400
-600
-800
-1000
APPLIED VOLTAGE (V)

FIG.4

VICKERS HARDNESS (kg/mm2)
8000
6000
4000
2000
0
2
10
20
Si CONTENT IN FILM (atm%)

FIG.5

ADHESIVE STRENGTH (kg/mm2)
100
50
0
2
10
20
Si CONTENT IN FILM (atm%)

FIG.6

INTERNAL STRESS
( ×10¹⁰dyn/m² )
3
2
1
0
2
10
20
Si CONTENT IN FILM (atm%)

FIG. 7

74
73
72
73
72
75
71

FIG. 8

85
86
3
87
RF POWER SUPPLY
MATCHING CIRCUIT
2
71
74
81
B
83
84

FIG.9

93
92
91

FIG.10

3
MATCHING CIRCUIT
RF POWER SUPPLY
21
1
2
4
22

FIG. 11

34
MATCHING CIRCUIT
RF POWER CIRCUIT
33
3
32

FIG. 12

DIELECTRIC BREAKDOWN VOLTAGE (V/μm)
400
200
MULTILAYER FILM C
MULTILAYER FILM B
MULTILAYER FILM A
FILM D PRODUCED BY CONVENTIONAL METHOD